# EUROPEAN PATENT APPLICATION

(11) **EP 4 683 451 A1**
(43) Date of publication of application: **21.01.2026**
(21) Application number: 25170645.3
(22) Date of filing: 15.04.2025
(51) Int. Cl.: H10B 12/00

(54) **SEMICONDUCTOR DEVICES**

(30) Priority: 17.07.2024 KR 20240094113
(71) Applicant: Samsung Electronics Co., Ltd., Suwon-si, Gyeonggi-do 16677 (KR)
(72) Inventor: PARK, Taejin, Suwon-si, Gyeonggi-do 16677 (KR); CHOI, Hyungeun, Suwon-si, Gyeonggi-do 16677 (KR); YIM, Sungsoo, Suwon-si, Gyeonggi-do 16677 (KR); KIM, Suklae, Suwon-si, Gyeonggi-do 16677 (KR); KIM, Cheonbae, Suwon-si, Gyeonggi-do 16677 (KR)
(74) Representative: Kuhnen & Wacker Patent- und Rechtsanwaltsbüro PartG mbB

(57) **Abstract**

A semiconductor device includes a transistor on a substrate, a first wiring structure on and electrically connected to the transistor, an insulation pattern extending through the substrate, a second wiring structure under the substrate, a plurality of through vias in the insulation pattern and spaced apart from each other in a horizontal direction, extending through the insulation pattern and contacting a portion of each of the first and second wiring structures, a bit line structure under and electrically connected to the second wiring structure, a gate electrode under the bit line structure and electrically connected to the second wiring structure, a channel adjacent to the gate electrode and contacts the bit line structure, and a capacitor under and electrically connected to the channel.

## Description

### CROSS-REFERENCE TO RELATED APPLICATION

This application claims priority to Korean Patent Application No. 10-2024-0094113 filed on July 17, 2024 in the Korean Intellectual Property Office, the disclosure of which is hereby incorporated by reference in its entirety.

### BACKGROUND

### TECHNICAL FIELD

Example embodiments of the present disclosure relate to semiconductor devices. More particularly, example embodiments of the present disclosure relate to dynamic random access memory (DRAM) devices.

### DESCRIPTION OF RELATED ART

In order to improve an integration degree of a semiconductor device, a method of arranging memory cells and periphery circuit patterns for generating electrical signals to drive the memory cells is needed.

### SUMMARY

Some example embodiments of the present disclosure provide semiconductor device having improved characteristics.

According to an example embodiment, a semiconductor device may include a transistor on a substrate, a first wiring structure on the transistor, a portion of the first siring structure being electrically connected to the transistor, an insulation pattern extending through the substrate, a second wiring structure under the substrate, a plurality of through vias in the insulation patter and spaced apart from each other in a horizontal direction parallel to an upper surface of the substrate, each of the plurality of through vias extending through the insulation pattern and contacting a portion of each of the first and second wiring structures, a bit line structure under the second wiring structure, the bit line structure being electrically connected to a portion of the second wiring structure, a gate electrode under the bit line structure, the gate electrode being electrically connected to a portion of the second wiring structure, a channel adjacent to the gate electrode, the channel contacting the bit line structure, and a capacitor under the channel, the capacitor being electrically connected to the channel.

According to an example embodiment, a semiconductor device may include a transistor under a substrate, a first wiring structure under the transistor, a portion of the first wiring structure being electrically connected to the transistor, an insulation pattern extending through the substrate, a second wiring structure on the substrate, a plurality of through vias in the insulation pattern and spaced apart from each other in a horizontal direction parallel to an upper surface of the substrate, each of the plurality of through vias extending through the insulation pattern and contacting a portion of each of the first and second wiring structures, a bit line structure on the second wiring structure, the bit line structure being electrically connected to a portion of the second wiring structure, a gate electrode on the bit line structure, the gate structure being electrically connected to a portion of the second wiring structure, a channel adjacent to the gate electrode, the channel contacting the bit line structure, and a capacitor on the channel, the capacitor being electrically connected to the channel.

According to an example embodiment, a semiconductor device may a periphery circuit region including a transistor on a substrate and the first wiring structure on the transistor, a portion of the first wiring structure being electrically connected to the transistor, a bonding pattern structure on the periphery circuit region, the bonding pattern structure being in contact with a portion of the first wiring structure, a first cell array region on the bonding pattern structure, the first cell array region including a first bit line structure, a first gate electrode, a first capacitor and a first channel, wherein the first bit line structure, the first gate electrode and the first capacitor are sequentially stacked in a vertical direction perpendicular to an upper surface of the substrate and the first channel is adjacent to the first gate electrode in a horizontal direction parallel to the upper surface of the substrate and contacts the first bit line structure, and a second cell array region on the first cell array region, the second cell array region including a second bit line structure, a second gate electrode, a second capacitor and a second channel, the second bit line structure, the second gate electrode and the second capacitor are sequentially stacked in the vertical direction, and the second channel is adjacent to the second gate electrode and contacts the second bit line structure.

According to an example embodiment, a method of manufacturing a semiconductor device may include forming an insulation pattern extending through a substrate, forming a first wiring structure on the substrate, forming a second wiring structure under the substrate, and forming a plurality of through vias in the insulation pattern and spaced apart from each other in a horizontal direction parallel to an upper surface of the substrate such that each of the plurality of through vias extending through the insulation pattern and contacting a portion of each of the first and second wiring structure.

The method may further include forming a cell array structure including a bit line, a cell transistor, and a capacitor such that each of the bit line structure and a gate electrode of the cell transistor are electrically connected to the second wiring structure.

In the semiconductor device in accordance with some example embodiments, the memory cells, the peripheral circle pattern and the wiring structure may be efficiently arranged, and thus the semiconductor device may have an enhanced integration degree.

### BRIEF DESCRIPTION OF THE DRAWINGS

FIG. 1 is a cross-sectional view illustrating a semiconductor device in accordance with an example embodiment, FIG. 2 is a plan view illustrating a layout of the second through vias included in the semiconductor device in accordance with an example embodiment.
FIGS. 3 to 14 are cross-sectional views and plan views illustrating a method of manufacturing a semiconductor device in accordance with an example embodiment.
FIG. 15 is a cross-sectional view illustrating a semiconductor device in accordance with an example embodiment.
FIGS. 16 and 17 are cross-sectional views illustrating a method of manufacturing a semiconductor device in accordance with an example embodiment.
FIG. 18 is a cross-sectional view illustrating a semiconductor device in accordance with an example embodiment.
FIGS. 19 and 20 are cross-sectional views illustrating a method of manufacturing the semiconductor device of FIG. 18 in accordance with an example embodiment.
FIG. 21 is a cross-sectional view illustrating a semiconductor device in accordance with an example embodiment.
FIGS. 22 and 23 are cross-sectional views illustrating a method of manufacturing the semiconductor device of FIG. 21 in accordance with an example embodiment.
FIGS. 24 to 26 are cross-sectional views illustrating a semiconductor device in accordance with some example embodiments.
FIG. 27 is a cross-sectional view illustrating a semiconductor device in accordance with an example embodiment.
FIG. 28 is a cross-sectional view illustrating a method of manufacturing the semiconductor device of FIG. 27 in accordance with an example embodiment.
FIG. 29 is a cross-sectional view illustrating a semiconductor device in accordance with an example embodiment.
FIG. 30 is a cross-sectional view illustrating a method of manufacturing the semiconductor device of FIG. 29 in accordance with an example embodiment.
FIG. 31 is a cross-sectional view illustrating a semiconductor device in accordance with an example embodiment.
FIG. 32 is a cross-sectional view illustrating a method of manufacturing the semiconductor device of FIG. 31 in accordance with an example embodiment.
FIG. 33 is a cross-sectional view illustrating a semiconductor device in accordance with an example embodiment.
FIG. 34 is a cross-sectional view illustrating a semiconductor device in accordance with an example embodiment.
FIGS. 35 to 40 are cross-sectional views illustrating a method of manufacturing the semiconductor device of FIG. 34 in accordance with an example embodiment.
FIGS. 41 to 43 are cross-sectional views illustrating a semiconductor device in accordance with some example embodiments.
FIG. 44 is a cross-sectional view illustrating a semiconductor device stacked structure in accordance with an example embodiment.
FIG. 45 is a cross-sectional view illustrating a semiconductor device in accordance with an example embodiment.
FIGS. 46 and 47 are cross-sectional views illustrating a semiconductor device in accordance with an example embodiment.

### DETAILED DESCRIPTION

The above and other aspects and features of semiconductor devices and methods of manufacturing the same in accordance with example embodiments will become readily understood from detail descriptions that follow, with reference to the accompanying drawings. It will be understood that, although the terms "first," "second," and/or "third" may be used herein to describe various materials, layers (films), regions, electrodes, pads, patterns, structures and processes, these materials, layers (films), regions, electrodes, pads, patterns, structures and processes should not be limited by these terms. These terms are only used to distinguish one material, layer (film), region, electrode, pad, pattern, structure and process from another material, layer (film), region, electrode, pad, pattern, structure and process. Thus, a first material, layer (film), region, electrode, pad, pattern, structure and process discussed below could be termed a second or third material, layer (film), region, electrode, pad, pattern, structure and process without departing from the teachings of inventive concepts.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

Hereinafter, in the specification (and not necessarily in the claims), two directions that are substantially perpendicular to each other among horizontal directions, which are substantially parallel to an upper surface of each of first, second and third substrates, may be referred to as first and second directions D1 and D2, respectively, and a vertical direction substantially perpendicular to the upper surface of each of the first to third substrates may be referred to as a third direction D3. In some example embodiments, the first and second directions D1 and D2 may be orthogonal to each other. Each of the first to third directions D1, D2 and D3 may include not only a direction shown in the drawings but also a direction that is inverse thereto.

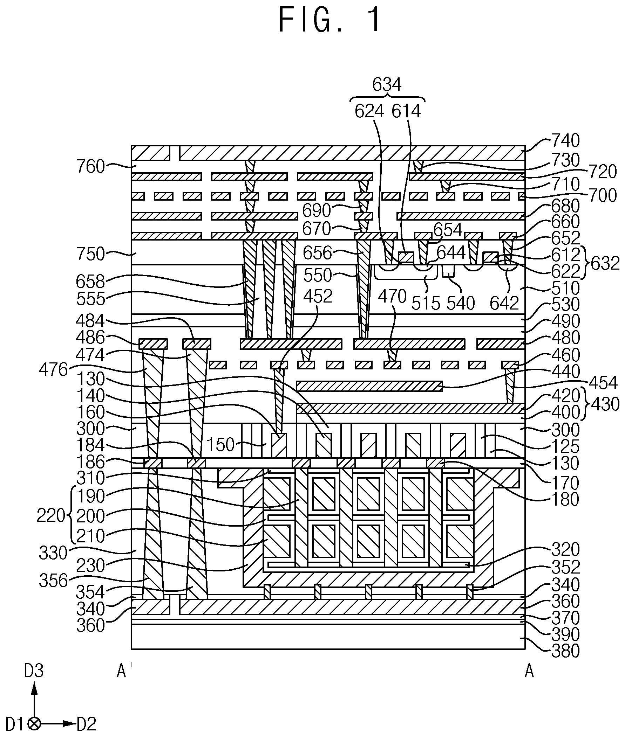

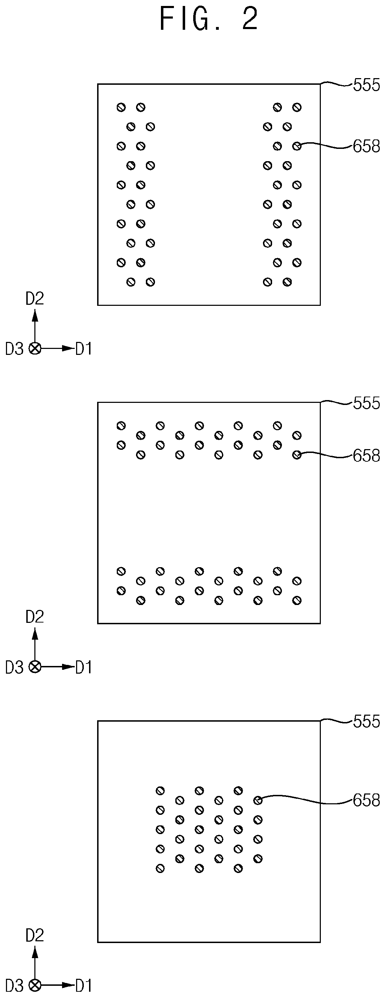

FIG. 1 is a cross-sectional view illustrating a semiconductor device in accordance with an example embodiment, and FIG. 2 is a plan view illustrating a layout of second through vias included in the semiconductor device in accordance with an example embodiment.

Referring to FIG. 1, the semiconductor device may include memory cells on a second substrate 380 and a periphery circuit pattern for generating electrical signals to drive the memory cells on a third substrate 510. Hereinafter, regions in which the memory cells and the periphery circuit pattern are disposed may be referred to as a cell array region and a periphery circuit region, respectively.

Thus, the semiconductor device may have a periphery over cell (POC) structure in which the peripheral circuit region is disposed over the cell array region. However, the inventive concepts are not limited thereto. In some example embodiments, the semiconductor device may have a cell over periphery (COP) structure in which the peripheral circuit region is disposed under the cell array region, which is further illustrated.

The semiconductor device may include a first capacitor 220, a first plate electrode 230, first to third conductive pads 180, 184 and 186, first and second gate electrodes 140 and 160, first and second gate insulation patterns 130 and 150, a first channel 125, a first bit line structure 430, first and second transistors and a wiring structure.

The semiconductor device may further include first and second bonding layers 390 and 530, first to seventh insulating interlayers 300, 170, 330, 370, 490, 750 and 760, and first and second insulation patterns 550 and 555.

The second substrate 380 may include a semiconductor material (e.g., silicon) or an insulating material (e.g., glass). The first bonding layer 390 may be bonded with an upper surface of the second substrate 380, and may include, for example, silicon carbonitride, silicon oxide, etc. The fourth insulating interlayer 370 may be bonded with an upper surface of the first bonding layer 390, and may include an oxide, for example, silicon oxide or a low-k dielectric material.

A first wiring 360 and a second etch stop layer 340 may be sequentially stacked in the third direction D3 on the fourth insulating interlayer 370. The second etch stop layer 340 may include an insulating nitride (e.g., silicon nitride).

Each of the second and third contact plugs 354 and 356 may extend through the third insulating interlayer 330 and the second etch stop layer 340 in the third direction D3, and may contact an upper surface of the first wiring 360. In some example embodiments, a width in the horizontal direction of each of the second and third contact plugs 354 and 356 may gradually decrease from a bottom to a top thereof.

The first capacitor 220 and the first plate electrode 230 may be disposed on the second etch stop layer 340 and in the third insulating interlayer 330, and a lower surface and a sidewall of the first plate electrode 230 may be covered by the third insulating interlayer 330. The first capacitor 220 may include a first capacitor electrode 190, a first dielectric layer 200 and a second capacitor electrode 210.

The first capacitor electrode 190 may extend in the third direction D3, and a plurality of first capacitor electrodes 190 may be spaced apart from each other in each of the first and second directions D1 and D2. In some example embodiments, the first capacitor electrode 190 may be arranged in a lattice pattern or a honeycomb pattern in a plan view.

A first support layer 320 and a first etch stop layer 310 may be disposed on a sidewall of each of the first capacitor electrodes 190. The first etch stop layer 310 may be disposed on an uppermost portion of the sidewall of each of the first capacitor electrodes 190, and a plurality of first support layers 320 may be spaced apart from each other in the third direction D3 on the sidewall of each of the first capacitor electrodes 190.

The first dielectric layer 200 may be disposed on the sidewall of the first capacitor electrode 190, lower and upper surfaces and a sidewall of the first support layer 320, and a lower surface and a sidewall of the first etch stop layer 310. The second capacitor electrode 210 may be disposed between a pair of the first support layers 320 neighboring in the third direction D3 and between an uppermost one of the first support layers 320 and the first etch stop layer 310, and lower and upper surfaces and a sidewall of the second capacitor electrode 210 may be covered by the first dielectric layer 200.

The first plate electrode 230 may surround lower surfaces and sidewalls of the first capacitor 220, the first support layer 320 and the first etch stop layer 310.

Each of the first and second capacitor electrodes 190 and 210 may include, for example, metal, metal nitride, metal silicide, etc., and the first dielectric layer 200 may include metal oxide. The first support layer 320 may include an insulating nitride (e.g., silicon nitride), and the first etch stop layer 310 may include an insulating nitride (e.g., silicon boronitride). The first plate electrode 230 may include, for example, doped silicon-germanium, or metal (e.g., tungsten).

A first contact plug 352 may extend through a lower portion of the third insulating interlayer 330 and the second etch stop layer 340, and may contact the upper surface of the first wiring 360 and a lower surface of the first plate electrode 230. The first contact plug 352 may extend partially through a lower portion of the first plate electrode 230.

The second insulating interlayer 170 may be disposed on the third insulating interlayer 330, the first capacitor 220, the first plate electrode 230 and second and third contact plugs 354 and 356. The first to third conductive pads 180, 184 and 186 may extend through the second insulating interlayer 170, and may contact upper surfaces of the first capacitor electrode 190, the second contact plug 354 and the third contact plug 356, respectively. As the first capacitor electrodes 190 are arranged in, for example, the lattice pattern or honeycomb pattern, the first conductive pads 180 may also be arranged in the lattice pattern or honeycomb pattern, corresponding to the first capacitor electrodes 190.

The second insulating interlayer 170 may include oxide (e.g., silicon oxide) or a low-k dielectric material. In some example embodiments, each of the first to third conductive pads 180, 184, 186 may include a second conductive pattern and a first conductive pattern that are sequentially stacked in the third direction D3. The second conductive pattern may include for example, metal, metal nitride, metal silicide, etc., and the first conductive pattern may include for example, doped polysilicon etc.

In some example embodiments, the first gate electrode 140 may extend in the first direction D1 on the second insulating interlayer 170, and a plurality of first gate electrodes 140 may be spaced apart from each other in the second direction D2. The second gate electrode 160 may extend in the first direction D1 on the second insulating interlayer 170, and a plurality of second gate electrodes 160 may be spaced apart from each other in the second direction D2. In some example embodiments, the first and second gate electrodes 140 and 160 may be alternately and repeatedly arranged in the second direction D2.

In some example embodiments, the first gate electrode 140 may have a straight bar shape extending in the first direction D1 in a plan view, while the second gate electrode 160 may include an extension portion straightly extending in the first direction D1 and protrusion portions, each of which may protrude in the second direction D2 from the extension portion, spaced apart from each other in the first direction D1.

Each of the first and second gate electrodes 140 and 160 may include metal (e.g., tungsten, copper, aluminum, etc.).

In some example embodiments, the second gate electrode 160 may serve as a word line of the semiconductor device, and the first gate electrode 140 may serve as a back gate electrode of the semiconductor device. However, the inventive concepts are not limited thereto. For example, the first gate electrode 140 may serve as the word line of the semiconductor device, and the second gate electrode 160 may serve as the back gate electrode of the semiconductor device.

In some example embodiments, the first gate insulation pattern 130 may be disposed on the second insulating interlayer 170 and the first conductive pad 180, and may extend in the first direction D1 and cover an upper surface and a sidewall of the first gate electrode 140. The second gate insulation pattern 150 may be disposed on the second insulating interlayer 170 and the first conductive pad 180, and may extend in the first direction D1 and cover an upper surface and a sidewall of the second gate electrode 160. A cross-section of each of the first and second gate insulation patterns 130 and 150 in the second direction D2 may have, e.g., a reversed cup shape.

As the first and second gate electrodes 140 and 160 are alternately and repeatedly arranged in the second direction D2, the first and second gate insulation patterns 130 and 150 may also be alternately and repeatedly arranged in the second direction D2.

In some example embodiments, each of opposite sidewalls in the second direction D2 of the first gate insulation pattern 130 may have a shape of a straight bar extending in the first direction D1 in a plan view, while each of opposite sidewalls in the second direction D2 of the second gate insulation pattern 150 may have a zigzag pattern in a plan view. Each of the first and second gate insulation patterns 130 and 150 may include oxide (e.g., silicon oxide).

The first channel 125 may be disposed on an outer sidewall of the first gate insulation pattern 130 in the second direction D2 and on the first conductive pad 180, and a plurality of first channels 125 may be spaced apart from each other in the first direction D1. A first sidewall in the second direction D2 of each of the first channels 125 may contact the outer sidewall in the second direction D2 of the first gate insulation pattern 130, and a second sidewall in the second direction D2 and opposite sidewalls in the first direction D1 of each of the first channels 125 may contact an outer sidewall in the second direction D2 of the second gate insulation pattern 150.

In some example embodiments, the first channel 125 may include a semiconductor material (e.g., silicon, germanium, silicon-germanium, etc.). In some example embodiments, the first channel 125 may include an oxide semiconductor material (e.g., IGZO).

The first insulating interlayer 300 may be disposed on the second insulating interlayer 170 and the second and third pads 184 and 186, and may contact a sidewall of one of the first gate insulation patterns 130 at each of opposite sides in the second direction D2. The first insulating interlayer 300 may include oxide (e.g., silicon oxide) or a low-k dielectric material.

The first bit line structure 430 may extend in the second direction D2 on the first channel 125, the first and second gate insulation patterns 130 and 150 and the first insulating interlayer 300, and a plurality of first bit line structures 430 may be spaced apart from each other in the first direction D1. Each of the first bit line structures 430 may commonly contact upper surfaces of ones of the first channels 125 disposed in the second direction D2.

In an example embodiment, each of the first bit line structures 430 may include third and fourth conductive patterns 400 and 420 stacked in the third direction D3, and may include, for example, doped polysilicon and metal, respectively.

Second to sixth wirings 440, 460, 480 484 and 486, fourth to seventh contact plugs 452, 454, 474 and 476, and a first via 470 may be disposed in a fifth insulating interlayer 490 that may be disposed on the first channel 125, the first and second gate insulation patterns 130 and 150, the first insulating interlayer 300, and the second and third conductive pads 184 and 186.

The second to fourth wirings 440, 460 and 480 may be sequentially stacked in the third direction D3 in this order, and the fifth and sixth wirings 484 and 486 may be spaced apart from the fourth wiring 480 in the horizontal direction at a level substantially the same as a level of the fourth wiring 480.

The fourth contact plug 452 may extend through a portion of the fifth insulating interlayer 490 and the second gate insulation pattern 150, and may contact a lower surface of the third wiring 460 and the upper surface of the second gate electrode 160. The fifth contact plug 454 may extend through a portion of the fifth insulating interlayer 490, and may contact the lower surface of the third wiring 460 and an upper surface of the first bit line structure 430. The sixth contact plug 474 may extend through the fifth insulating interlayer 490, and may contact a lower surface of the fifth wiring 484 and an upper surface of the second conductive pad 184. The seventh contact plug 476 may extend through the fifth insulating interlayer 490, and may contact a lower surface of the sixth wiring 486 and an upper surface of the third conductive pad 186.

In some example embodiments, each of the fourth to seventh contact plugs 452, 454, 474 and 476 may have a width that gradually increases from a bottom to a top thereof.

The first via 470 may extend through a portion of the fifth insulating interlayer 490, and may contact an upper surface of the third wiring 460 and a lower surface of the fourth wiring 480.

The fifth insulating interlayer 490 may include oxide (e.g., silicon oxide) or a low-k dielectric material.

The second bonding layer 530 may be bonded with an upper surface of the fifth insulating interlayer 490, and may include, for example, silicon carbonitride, silicon oxide, etc.

The third substrate 510 may be disposed on the second bonding layer 530. The third substrate 510 may include a semiconductor material, for example, silicon, germanium, silicon-germanium, etc., and a well region doped with, for example, p-type impurities, may be disposed in the third substrate 510.

An isolation pattern 540 may be formed at an upper portion of the third substrate 510. Each of the first and second insulation patterns 550 and 555 may extend through the third substrate 510, the second bonding layer 530 and an upper portion of the fifth insulating interlayer 490, and may contact an upper surface of the third wiring 480. FIG. 1 shows one first insulation pattern 550 and one second insulation pattern 555, however, the inventive concepts are not limited thereto. Thus, a plurality of first insulation patterns 550 may be disposed, and a plurality of second insulation patterns 555 may be disposed.

Each of the isolation patterns 540 and the first and second insulation patterns 550 and 555 may include oxide (e.g., silicon oxide).

First and second gate structures 632 and 634 may be disposed on the third substrate 510, and second and third impurity regions 642 and 644 may be formed at upper portions of the third substrate 510 adjacent to the first and second gate structures 632 and 634, respectively. In an example embodiment, the second impurity region 642 may include n-type impurities, and the third impurity region 644 may include p-type impurities. A first impurity region 515 doped with n-type impurities may be further formed at a portion of the third substrate 510 under the second gate structure 634, and may surround the third impurity region 644.

The first gate structure 632 may include a third gate insulation pattern 622 and a third gate electrode 612 stacked in the third direction D3, and the second gate structure 634 may include a fourth gate insulation pattern 624 and a fourth gate electrode 614 stacked in the third direction D3.

The first gate structure 632 and the second gate impurity regions 642 may collectively form a first transistor, and the second gate structure 634 and the third impurity regions 644 may collectively form a second transistor. The first transistor may be an NMOS transistor, and the second transistor may be a PMOS transistor. FIG. 1 shows that the first and second transistors, which are the NMOS and PMOS transistors, respectively, however, the inventive concepts are not limited thereto. For example, a plurality of NMOS transistors and a plurality of PMOS transistors may be disposed.

Each of the third and fourth gate electrodes 612 and 614 may include a conductive material (e.g., metal, metal nitride, metal silicide, etc.), and each of the third and fourth gate insulation patterns 622 and 624 may include oxide (e.g., silicon oxide).

The sixth and seventh insulating interlayers 750 and 760 may be stacked in the third direction D3 on the third substrate 510. Each of the sixth and seventh insulating interlayers 750 and 760 may include oxide (e.g., silicon oxide) or a low-k dielectric material.

Eighth and ninth contact plugs 652 and 654 may extend through the sixth insulating interlayer 750, and may contact upper surfaces of the second and third impurity regions 642 and 644, respectively. A first through via 656 may extend through the sixth insulating interlayer 750 and the second insulation pattern 550, and may contact the upper surface of the fourth wiring 480.

Seventh to eleventh wirings 660, 680, 700, 720 and 740 may be sequentially stacked in the third direction D3 in this order.

A tenth contact plug 670 may extend through a portion of the seventh insulating interlayer 760, and may contact an upper surface of the seventh wiring 660 and a lower surface of the eighth wiring 680. An eleventh contact plug 690 may extend through a portion of the seventh insulating interlayer 760, and may contact an upper surface of the eighth wiring 680 and a lower surface of the ninth wiring 700. A twelfth contact plug 710 may extend through a portion of the seventh insulating interlayer 760, and may contact an upper surface of the ninth wiring 700 and a lower surface of the tenth wiring 720. A second via 730 may extend through a portion of the seventh insulating interlayer 760, and may contact an upper surface of the tenth wiring 720 and a lower surface of the eleventh wiring 740.

FIG. 1 shows that the seventh to eleventh wirings 660, 680, 700, 720 and 740 stacked at four levels, respectively, in the third direction D3 in the seventh insulating interlayer 760, however, the inventive concepts are not limited thereto.

Each of the first to eleventh wirings 360, 440, 460, 480, 484, 486, 660, 680, 700, 720 and 740, the first to twelfth contact plugs 352, 354, 356, 452, 454, 476, 652, 654, 670, 690 and 710, the first and second through via 656 and 658, and the first and second vias 470 and 730 included in the wiring structure may include, for example, metal, metal nitride, metal silicide, etc.

The wiring structure may include a signal line for transferring an electric signal generated from the periphery circuit pattern to the memory cells, and a power line for providing power to the periphery circuit pattern and the memory cells.

In an example embodiment, the signal line may be disposed under and over the third substrate 510, and the power line may be disposed over the third substrate 510. The power line may include, e.g., the tenth to twelfth contact plugs 670, 690 and 710, the eighth to eleventh wirings 680, 700, 720 and 740, and the second via 730, however, the inventive concepts are not limited thereto.

In the semiconductor device, currents may flow in the first channel 125 in the third direction D3, which is vertical direction, between the first bit line structure 430 and the first conductive pad 180, and thus the semiconductor device may be a Vertical Channel Transistor (VCT) DRAM device that may include a vertical channel transistor having a vertical channel.

Referring to FIG. 2, a plurality of second through vias 658 may be spaced apart from each other in the first direction D1 and/or the second direction D2 in the second insulation pattern 555, in a plan view.

In an example embodiment, a plurality of second through vias 658 may be spaced apart in the first and second direction D1 and D2 at each of opposite sides in the first direction D1 of the second insulation pattern 555, in a plan view.

In an example embodiment, a plurality of second through vias 658 may be spaced apart in the first and second direction D1 and D2 at each of opposite sides in the second direction D2 of the second insulation pattern 555, in a plan view.

In an example embodiment, a plurality of second vias 658 may be spaced apart from each other in the first second direction D1 and D2 at a middle portion of the second insulation pattern 555, in a plan view.

The second through vias 658 may extend through the sixth insulating interlayer 750 and the second insulation pattern 555, and thus an additional insulating spacer may not be disposed in order to electrically insulate the second through vias 658 from each other.

That is, if the second through vias 658 extending through the third substrate 510 are disposed without the second insulation pattern 555 in the third substrate 510, an opening is formed through the third substrate 510, an insulating spacer is formed on a sidewall of the opening, and each of the second through vias 658 is formed at other portions of the opening in order to reduce or prevent the electrical short between the second through vias 658. Thus, the opening for forming the second through via 658 has to secure a width twice a thickness of the insulating spacer, resulting in an increased width. Accordingly, forming the second through vias 658 with a high density is not easy.

However, in some example embodiments, the second through vias 658 may extend through the second insulation pattern 555 in the third substrate 610, and thus an additional insulating spacer may not be formed in order to electrically insulate the second through vias 658 from each other. Accordingly, the opening may be formed to have a relatively small size, and the second vias 658 may have a relatively high density in a desired region. As a result, wirings included in the wiring structure may be arranged with a higher degree of freedom, and the semiconductor device may have an enhanced integration degree.

In the semiconductor device illustrated in FIGS. 1 and 2, the first plate electrode 230 in the cell array region may be disposed to face downwardly in the third direction D3, and each the first and second transistors in the periphery circuit region may be disposed to face upwardly in the third direction D3 on the third substrate 510.

However, the inventive concepts are not limited thereto, and for example, the first plate electrode 230 in the cell array region may be disposed to face upwardly in the third direction D3, or each the first and second transistors in the periphery circuit region may be disposed to face downwardly in the third direction D3 beneath the third substrate 510, which may be further illustrated below.

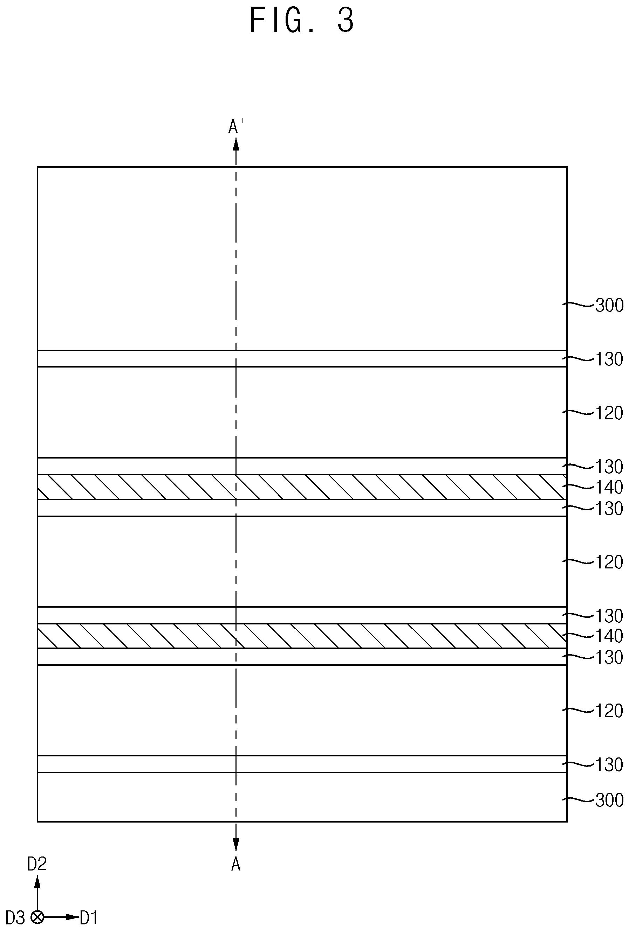

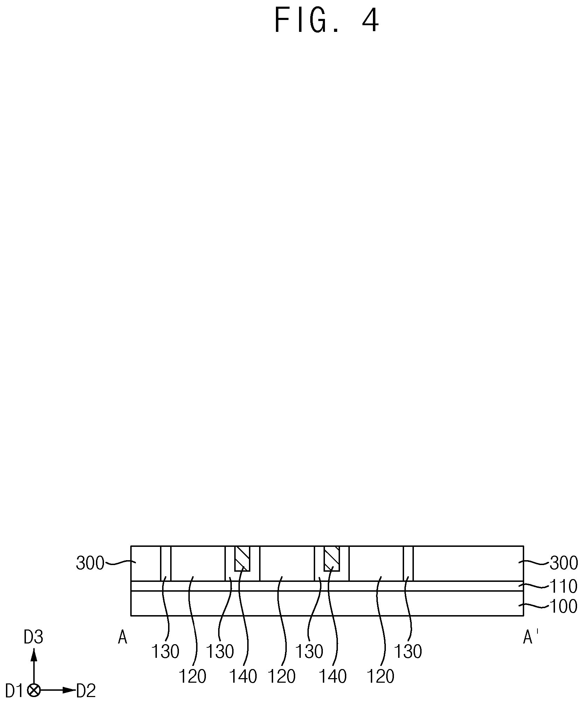

FIGS. 3 to 14 are plan views and cross-sectional views illustrating a method of manufacturing a semiconductor device in accordance with an example embodiment. Specifically, FIGS. 3, 5 and 7 are plan views, and FIGS. 4, 6 and 8-14 are cross-sectional views taken along lines A-A' of corresponding plan views, respectively.

Referring to FIGS. 3 and 4, a first substrate structure including a first bulk substrate 100, a buried oxide layer 110 and a second bulk substrate may be provided, and the second bulk substrate may be patterned to form a preliminary first channel 120.

In some example embodiments, the preliminary first channel 120 may extend in the first direction D1, and a plurality of preliminary first channels 120 may be spaced apart from each other in the second direction D2. A first opening may be formed between a pair of the preliminary first channels 120 neighboring in the second direction D2 to expose an upper surface of the buried oxide layer 110.

A first gate insulation layer may be formed on the preliminary first channel 120 and the buried oxide layer 110, an anisotropic etching process may be performed on the first gate insulation layer to remove a portion of the first gate insulation layer on an upper surface of the preliminary first channel 120. Thus, a first gate insulation pattern 130 may be formed on a sidewall of the first opening and the upper surface of the buried oxide layer 110. In some example embodiments, the first gate insulation pattern 130 may contact opposite sidewalls in the second direction D2 of respective ones of the preliminary first channels 120 neighboring in the second direction D2 and an upper surface of a portion of the buried oxide layer 110 between the neighboring ones of the preliminary first channels 120, and may extend in the first direction D1.

A first gate electrode layer may be formed on the preliminary first channel 120 and the first gate insulation pattern 130, and a planarization process may be performed on the first gate electrode layer until the upper surface of the preliminary first channel 120 and an upper surface of the first gate insulation pattern 130 are exposed to form a first gate electrode 140. The planarization process may include, for example, a chemical mechanical polishing (CMP) process and/or an etch back process.

In some example embodiments, the first gate electrode 140 may extend in the first direction D1, and a plurality of first gate electrodes 140 may be spaced apart from each other in the second direction D2.

The preliminary first channel 120, the first gate insulation pattern 130 and the first gate electrode 140 may be partially removed to form a second opening exposing the upper surface of the buried oxide layer 110, and a first insulating interlayer 300 may be formed in the second opening.

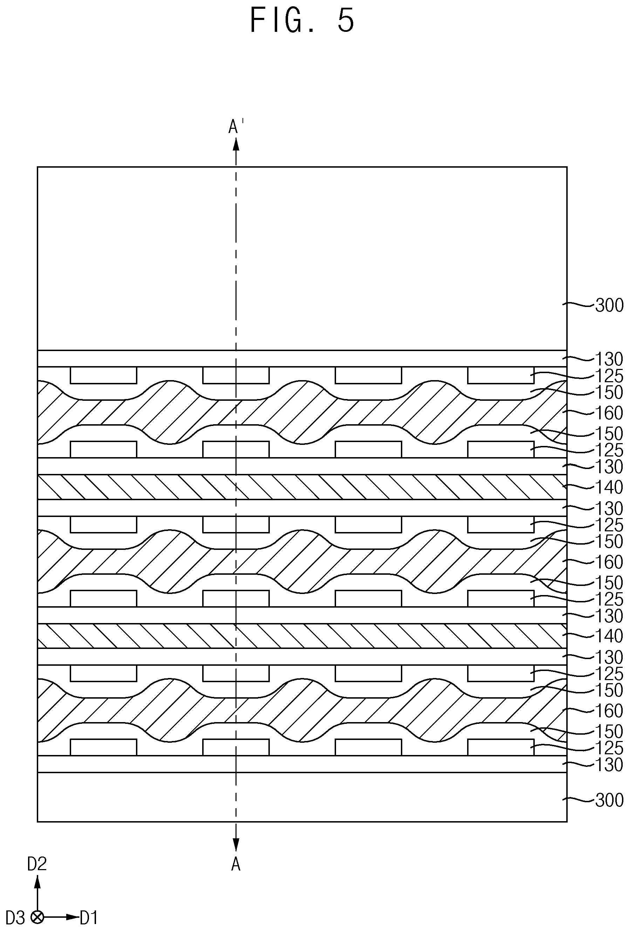

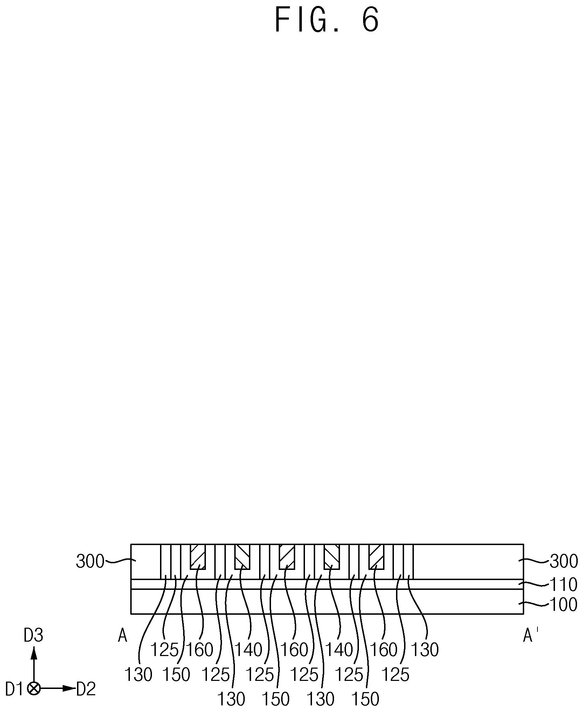

Referring to FIGS. 5 and 6, the preliminary first channel 120 may be patterned to form a channel 125.

In some example embodiments, a plurality of first channels 125 may be spaced apart from each other in the first direction D1 and on a sidewall in the second direction D2 of the first gate insulation pattern 130 extending in the first direction D1. A third opening may be formed between a pair of the first channels 125 that are disposed between a corresponding pair of the first gate insulation patterns 130 neighboring in the second direction D2, and may expose the upper surface of the buried oxide layer 110.

A second gate insulation layer may be formed on the first channel 125, the first gate insulation pattern 130, the first gate electrode 140 and the buried oxide layer 110, and a portion of the second gate insulation layer on an upper surface of the first channel 125, the upper surface of the first gate insulation pattern 130 and an upper surface of the first gate electrode 140 may be removed by, for example , an anisotropic etching process to form a second gate insulation pattern 150.

In some example embodiments, the second gate insulation pattern 150 may contact two sidewalls facing each other among the sidewalls in the second direction D2 of a pair of the first gate insulation patterns 130 neighboring in the second direction D2, two sidewalls facing each other among the sidewalls in the second direction D2 of a pair of the first channels 125 neighboring in the second direction D2, the upper surface of a portion of the buried oxide layer 110 between the neighboring ones of the first gate insulation patterns 130 and the upper surface of a portion of the buried oxide layer 110 between the neighboring ones of the first channels 125.

A second gate electrode layer may be formed on the first channel 125, the first and second gate insulation patterns 130 and 150, the first gate electrode 140 and the first insulating interlayer 300, and a planarization process may be performed on the second gate electrode layer until the upper surfaces of the first channel 125, the first gate insulation pattern 130 and the first gate electrode 140, and upper surfaces of the second gate insulation pattern 150 and the first insulating interlayer 300 are exposed to form a second gate electrode 160. The planarization process may include a CMP process and/or an etch back process.

In some example embodiments, the second gate electrode 160 may extend in the first direction D1, and a plurality of second gate electrodes 160 may be spaced apart from each other in the second direction D2. In some example embodiments, the second gate electrode 160 may include an extension portion straightly extending in the first direction D1 and protrusion portions that may protrude from the extension portion in the second direction D2 and be spaced apart from each other in the first direction D1, in a plan view.

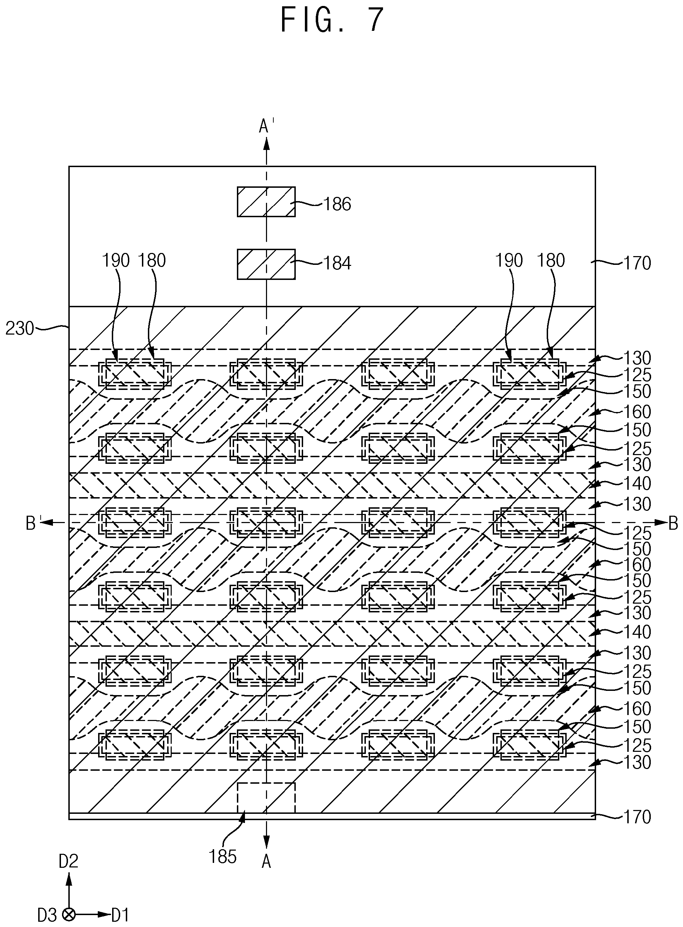

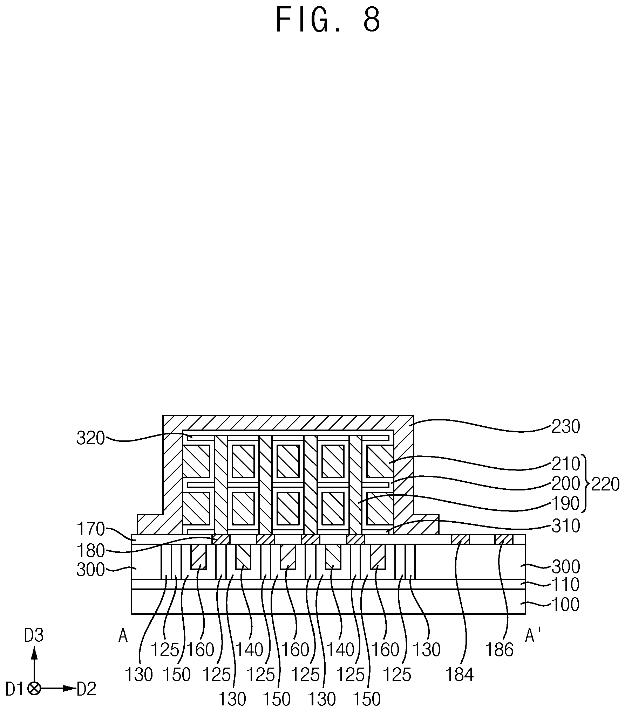

Referring to FIGS. 7 and 8, a second insulating interlayer 170 may be formed on the first and second gate electrodes 140 and 160, the first channel 125, the first and second gate insulation patterns 130 and 150 and the first insulating interlayer 300, and first to third conductive pads 180, 184 and 186 may be formed through the second insulating interlayer 170.

In some example embodiments, a plurality of first conductive pads 180 may be spaced apart from each other in each of the first and second directions D1 and D2 to contact upper surfaces of corresponding ones of the first channels 125, respectively. The second and third conductive pads 184, 186 may be formed through a portion of the second insulating interlayer 170 on the first insulating interlayer 300.

In some example embodiments, each of the first to third conductive pads 180, 184 and 186 may include first and second conductive patterns stacked in the third direction D3. The first conductive pattern may include, for example, doped polysilicon, and the second conductive pattern may include, for example, metal, metal nitride, metal silicide, etc.

A first capacitor 220 and a first plate electrode 230 may be formed on the second insulating interlayer 170 and the first conductive pad 180. The first capacitor 220 and the first plate electrode 230 may be formed by, for example, following processes.

A first etch stop layer 310 may be formed on the second insulating interlayer 170 and the first to third conductive pads 180, 184 and 186, and a mold layer and a first support layer 320 may be alternately and repeatedly formed on the first etch stop layer 310. The first etch stop layer 310 may include insulating nitride (e.g., silicon boronitride), the mold layer may include oxide (e.g., silicon oxide), and the first support layer 320 may include insulating nitride (e.g., silicon nitride).

A fourth opening may be formed through the first support layer 320, the mold layer and the first etch stop layer 310 to expose an upper surface of the first conductive pad 180, a first capacitor electrode layer may be formed on the upper surface of the first conductive pad 180, a sidewall of the fourth opening and an upper surface of an uppermost one of the first support layers 320, and a planarization process may be performed on the first capacitor electrode layer until the upper surface of the uppermost one of the first support layers 320 is exposed to form a first capacitor electrode 190 in the fourth opening.

The planarization process may include, for example, a CMP process and/or an etch back process.

The first support layer 320 and the mold layer may be partially removed to form a fifth opening exposing an upper surface of the first etch stop layer 310, and the mold layer may be removed through the fifth opening.

In some example embodiments, the mold layer may be removed by a wet etching process, and as the wet etching process is performed, a sixth opening may be formed to expose a sidewall of the first capacitor electrode 190 and the upper surface of the first etch stop layer 310. However, the first support layers 320 may remain on the sidewall of each of the first capacitor electrodes 190, and thus a surface of each of the first support layers 320 may be exposed by the sixth opening.

A first dielectric layer 200 may be formed on the sidewall of each of the first capacitor electrodes 190, the upper surface of the first etch stop layer 310 and the surface of each of the first support layers 320 exposed by the sixth opening, and a second capacitor electrode layer may be formed on the first dielectric layer 200 to fill the sixth opening. The first dielectric layer 200 and the second capacitor electrode layer may also be formed on an upper surface of the first capacitor electrode 190 and the upper surface of the uppermost one of the first support layers 320.

For example, a wet etching process may be performed on the second capacitor electrode layer to form a second capacitor electrode 210 in the sixth opening. The first capacitor electrode 190, the first dielectric layer 200 and the second capacitor electrode 210 may collectively form a first capacitor 220.

A first plate electrode 230 may be formed on an upper surface and a sidewall of the first capacitor 220 and an upper surface of the second insulating interlayer 170.

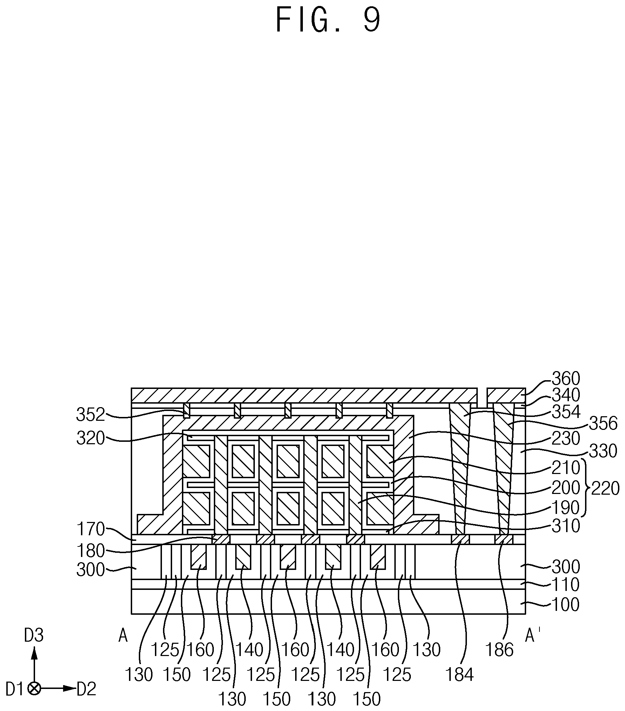

Referring to FIG. 9, a third insulating interlayer 330 may be formed on the second insulating interlayer 170 and the second and third conductive pads 184 and 186 to cover the first plate electrode 230, and a second etch stop layer 340 may be formed on the third insulating interlayer 330. A first contact plug 352 may be formed through the second etch stop layer 340 to contact an upper surface of the first plate electrode 230, and second and third contact plugs 354 and 356 may be formed through the second etch stop layer 340 and the third insulating interlayer 330 to contact upper surfaces of the second and third conductive pads 184 and 186, respectively.

In some example embodiments, each of the second and third contact plugs 354 and 356 may be formed to have a width that gradually decrease from top to bottom thereof, depending on the characteristics of an etching process for forming the second and third contact plugs 354 and 356.

A first wiring layer may be formed on the second etch stop layer 340 and the first to third contact plugs 352, 354 and 356, and may be partially etched to form a first wiring 360. The second etch stop layer 340 may also be partially etched so that a portion of an upper surface of the third insulating interlayer 330 may be exposed.

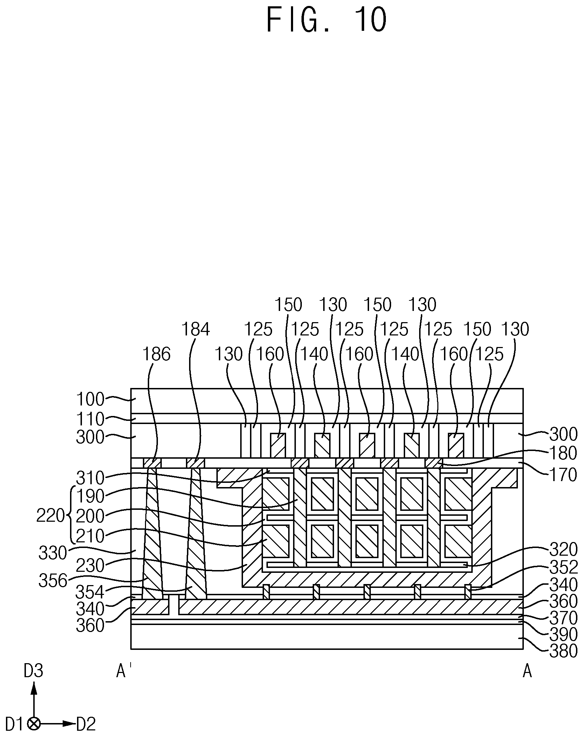

Referring to FIG. 10, a fourth insulating interlayer 370 may be formed on the third insulating interlayer 330 to cover the first wiring 360, and a second substrate 380 may be bonded with an upper surface of the fourth insulating interlayer 370 via a first bonding layer 390 therebetween.

The second substrate 380 may include a semiconductor material (e.g., silicon) or an insulating material (e.g., glass), and the first bonding layer 390 may include, for example, silicon carbonitride, silicon oxide, etc.

A structure including the first substrate structure and the second substrate 380 may be flipped so that top and bottom of the structure may be reversed. Thus, the following explanation is based on the reversed direction.

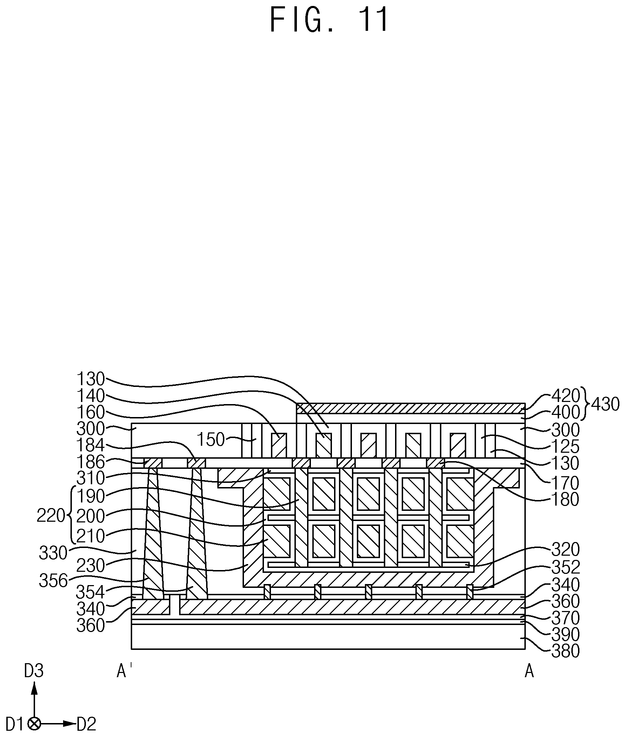

Referring to FIG. 11, the first bulk substrate 100 and the buried oxide layer 110 included in the first substrate structure may be removed by, for example, a grinding process, and thus upper surfaces of the first channel 125, the first and second gate insulation patterns 130 and 150 and the first insulating interlayer 300 may be exposed.

A first bit line structure 430 may be formed on the upper surfaces of the first channel 125, the first and second gate insulation patterns 130 and 150 and the first insulating interlayer 300. In some example embodiments, the first bit line structure 430 may extend in the second direction D2, and a plurality of first bit line structures 430 may be spaced apart from each other in the first direction D1. Each of the first bit line structures 430 may contact the upper surfaces of ones of the first channels 125 that are disposed in the second direction D2.

In an example embodiment, each of the first bit line structures 430 may include third and fourth conductive patterns 400 and 420 stacked in the third direction D3, which may include, for example, doped polysilicon and metal, respectively.

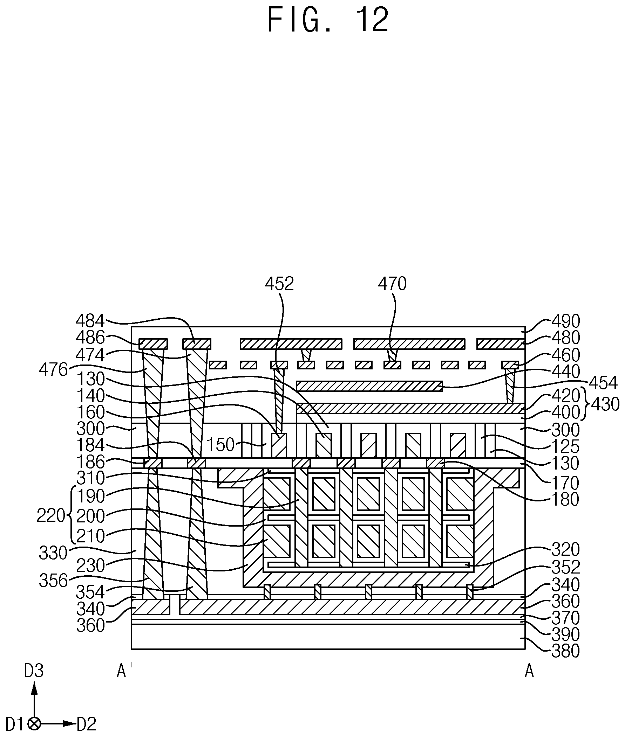

Referring to FIG. 12, second to sixth wirings 440, 460, 480, 484 and 486, fourth to seventh contact plugs 452, 454, 474 and 476 and a first via 470 may be formed on the first bit line structure 430, and a fifth insulating interlayer 490 may be formed on the first channel 125, the first and second gate insulation patterns 130 and 150 and the first insulating interlayer 300 to cover the second to sixth wirings 440, 460, 480, 484 and 486, the fourth to seventh contact plugs 452, 454, 474 and 476 and the first via 470.

In some example embodiments, each the fourth to seventh contact plugs 452, 454, 474 and 476 and the first via 470 may be formed to have a width that gradually decrease from top to bottom thereof, depending on the characteristics of etching processes for forming the fourth to seventh contact plugs 452, 454, 474 and 476 and the first via 470.

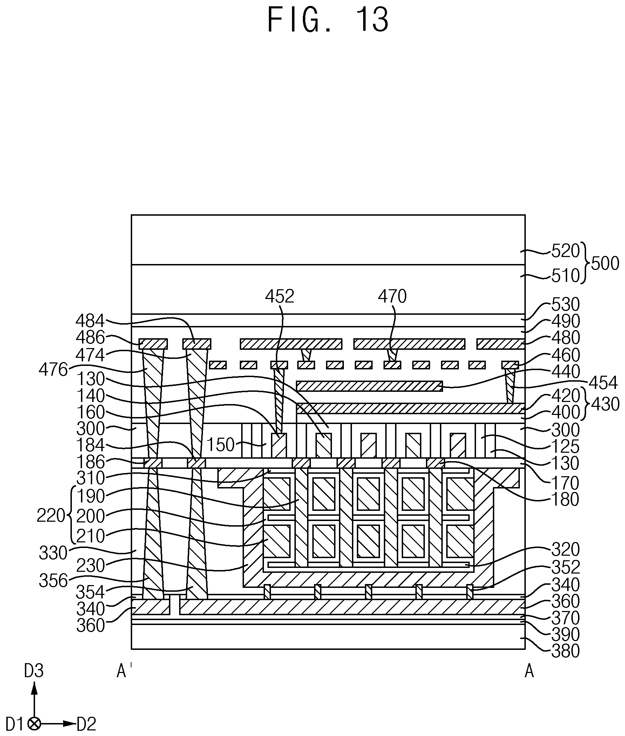

Referring to FIG. 13, a third substrate structure 500 may be bonded with an upper surface of the fifth insulating interlayer 490 via a second bonding layer 530 therebetween.

The third substrate structure 500 may be doped with, for example, p-type impurities, and may include first and second regions 510 and 520 having different impurity concentrations from each other. The second bonding layer 530 may include, for example, silicon carbonitride, silicon oxide, etc.

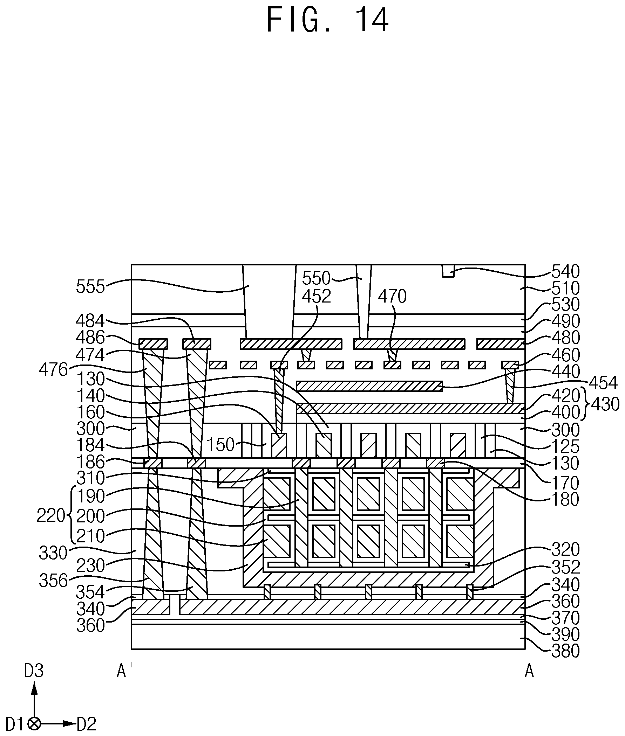

Referring to FIG. 14, the second region 520 of the third substrate structure 500 may be removed by, for example, a grinding process to expose an upper surface of the first region 510 of the third substrate structure 500.

Hereinafter, the first region 510 of the third substrate structure 500 may be referred to as a third substrate 510.

An isolation pattern 540 may be formed at an upper portion of the third substrate 510, and first and second insulation patterns 550 and 555 may be formed through the third substrate 510, the second bonding layer 530 and an upper portion of the fifth insulating interlayer 490 to contact an upper surface of the fourth wiring 480.

Referring to FIG. 1 again, a first impurity region 515 may be formed at an upper portion of the third substrate 510, first and second gate structures 632 and 634 may be formed on the third substrate 510, and second and third impurity regions 642 and 644 may be formed at upper portions of the third substrate 510 adjacent to the first and second gate structures 632 and 634, respectively. Thus, a first transistor including the first gate structures 632 and the second impurity regions 642 and a second transistor including the second gate structure 634 and the third impurity regions 644 may be formed.

A sixth insulating interlayer 750 may be formed on the third substrate 510 to cover the first and second transistors, and eighth and ninth contact plugs 652 and 654 extending through the sixth insulating interlayer 750 to contact upper surfaces of the second and third impurity regions 642 and 644, respectively, a first through via 656 extending through the sixth insulating interlayer 750 and the first insulation pattern 550 to contact the upper surface of the fourth wiring 480 and a second through via 658 extending through the sixth insulating interlayer 750 and the second insulation pattern 555 to contact the upper surface of the fourth wiring 480 may be formed.

In some example embodiments, a plurality of second through vias 658 may be spaced apart from each other in the first direction D1 and/or the second direction D2. The second through via 658 may be formed through the sixth insulating interlayer 750 and the second insulation pattern 555, and thus an additional insulating spacer may not be formed in order to electrically insulate the second through vias 658 from each other. Thus, an opening for forming the second through via 658 may be formed to have a relatively small size, and the second through vias 658 may be formed to have a relatively high density at a desired region.

Tenth to twelfth contact plugs 670, 690 and 710, seventh to eleventh wirings 670, 690, 700, 720 and 740, and a fourth via 730 may be formed on the sixth insulating interlayer 750, and a seventh insulating interlayer 760 may be formed on the sixth insulating interlayer 750 to cover the tenth to twelfth contact plugs 670, 690 and 710, the seventh to eleventh wirings 660, 680, 700, 720 and 740, and the fourth via 730 so that the fabrication of the semiconductor device may be completed.

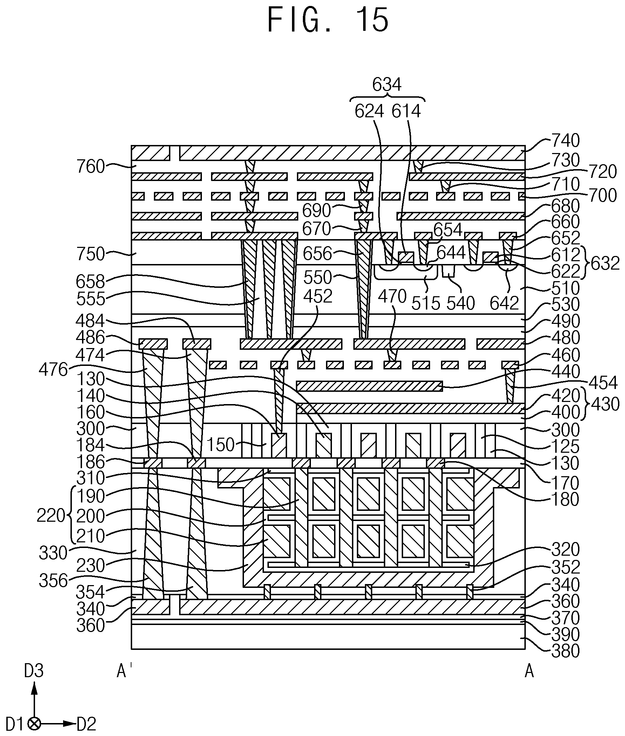

FIG. 15 is a cross-sectional view illustrating a semiconductor device in accordance with an example embodiment. This semiconductor device may be substantially the same as or similar to that of FIGS. 1 and 2 except for some elements, and thus repeated explanations are omitted herein.

Referring to FIG. 15, the first and second through vias 656 and 658 may extend through the first and second insulation patterns 550 and 555, respectively, which may extend through the sixth insulating interlayer 750, the third substrate 510, the second bonding layer 530 and the upper portion of the fifth insulating interlayer 490, and may contact the upper surface of the third wiring 480, and thus entire portions of sidewalls of the first and second through vias 656 and 658 may contact the first and second insulation patterns 550 and 555, respectively.

Each of the first and second insulation patterns 550 and 555 of FIG. 1 may extend through the third substrate 510, the second bonding layer 530 and the upper portion of the fifth insulating interlayer 490, upper and lower portions of the first through via 656 may contact the sixth insulating interlayer 750 and the first insulation pattern 550, respectively and upper and lower portion of the second through via 658 may contact the sixth insulating interlayer 750 and the second insulation pattern 555, respectively. The first and second through vias 656 and 658 of FIG. 15 may not contact the sixth insulating interlayer 750, but may contact only the first and second insulation patterns 550 and 555, respectively.

Each of the first and second insulation patterns 550 and 555 may include oxide (e.g., silicon oxide).

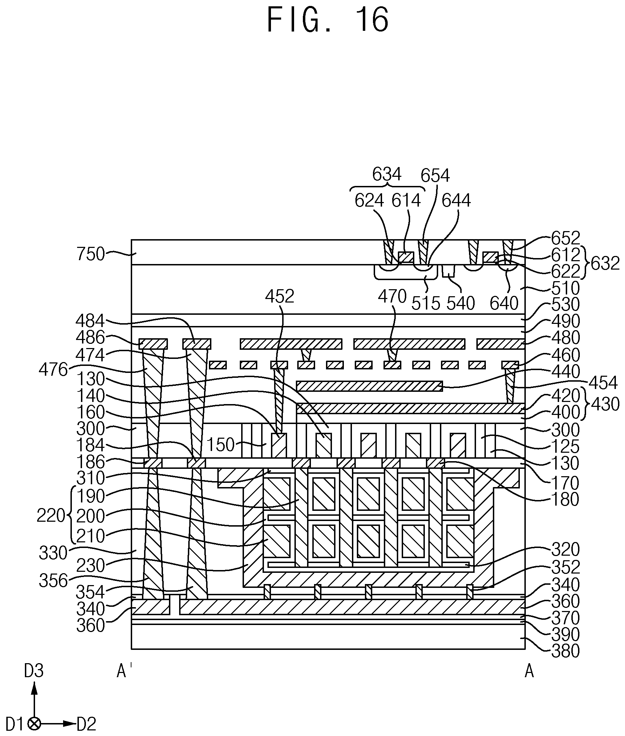

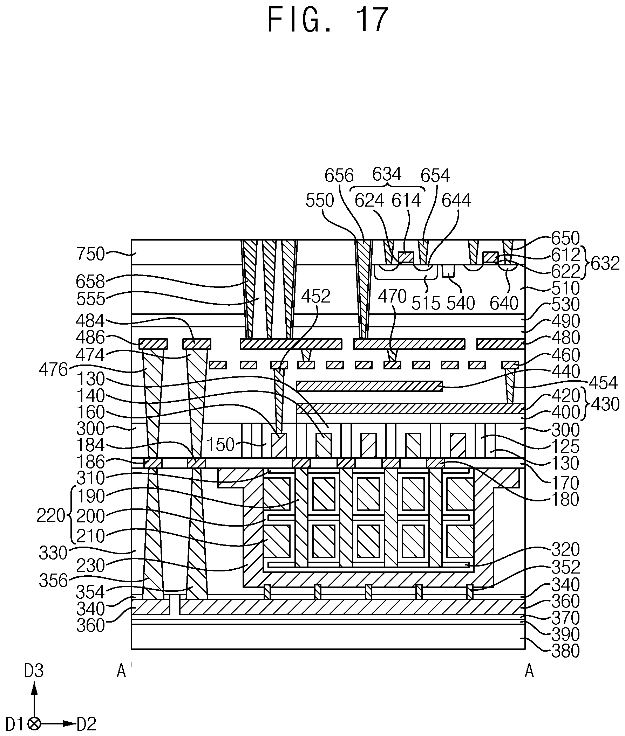

FIGS. 16 and 17 are cross-sectional views illustrating a method of manufacturing a semiconductor device, particularly, the semiconductor device of FIG. 15. This method may include processes substantially the same as or similar to those illustrated with respect to FIGS. 3 to 14 and FIGS. 1 and 2, and thus repeated explanations are omitted herein.

Referring to FIG. 16, processes substantially the same as or similar to those illustrated with respect to FIGS. 3 to 13 may be performed, and the second region 520 of the third substrate structure 500 may be removed by, for example, a grinding process to expose the upper surface of the first region 510 of the third substrate structure 500, that is, the upper surface of the third substrate 510.

The isolation pattern 540 may be formed at the upper portion of the third substrate 510, the first impurity region 515 and the first and second transistors may be formed, the sixth insulating interlayer 750 may be formed on the third substrate 510 to cover the first and second transistors, and the eighth and ninth contact plugs 652 and 654 may be formed through the sixth insulating interlayer 750 to contact upper surfaces of the second and third impurity regions 642 and 644, respectively.

Referring to FIG. 17, seventh and eighth openings may be formed through the sixth insulating interlayer 750, the third substrate 510, the second bonding layer 530 and the upper portion of the fifth insulating interlayer 490 to expose the upper surfaces of the fourth wirings 480, respectively, and the first and second insulation patterns 550 and 555 may be formed in the seventh and eighth openings, respectively.

Referring to FIG. 15 again, the first and second through vias 656 and 658 may be formed through the first and second insulation patterns 550 and 555, respectively, the tenth to twelfth contact plugs 670, 690 and 710, the seventh to eleventh wirings 660, 680, 700, 720 and 740, and the second via 730 may be formed on the sixth insulating interlayer 750 and the first and second through vias 656 and 658, and the sixth insulating interlayer 760 may be formed to cover the tenth to twelfth contact plugs 670, 690 and 710, the seventh to eleventh wirings 660, 680, 700, 720 and 740, and the second via 730, so that the fabrication of the semiconductor device may be completed.

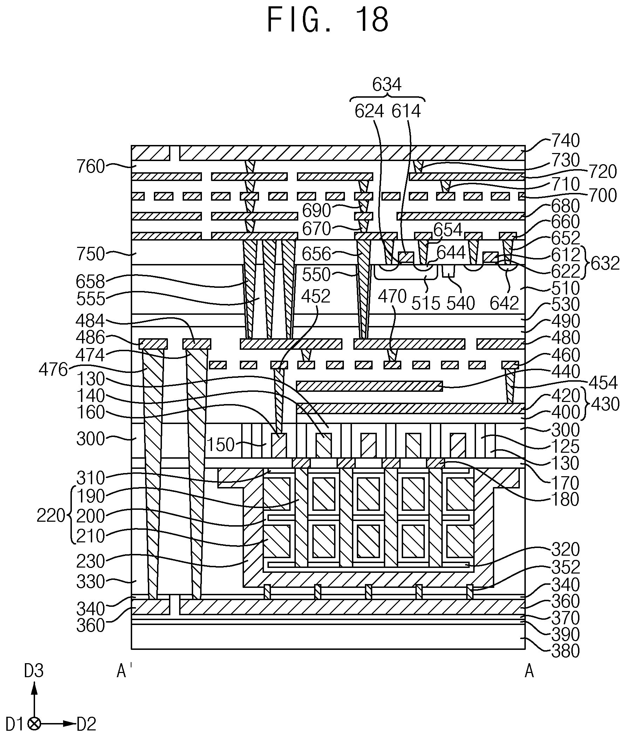

FIG. 18 is a cross-sectional view illustrating a semiconductor device in accordance with an example embodiment. This semiconductor device may be substantially the same as or similar to that of FIGS. 1 and 2 except for some elements, and thus repeated explanations are omitted herein.

Referring to FIG. 18, the second and third conductive pads 184 and 186 may not be formed in the second insulating interlayer 170, and the second and third contact plugs 354 and 356 may not be formed in the third insulating interlayer 330.

Each of the seventh and eighth contact plugs 474 and 476 may extend through the fifth insulating interlayer 490, the second and third insulating interlayers 170 and 330 and the second etch stop layer 340, and may contact the upper surface of the first wiring 360. The seventh and eighth contact plugs 474 and 476 may contact lower surfaces of the fifth and sixth wirings 484 and 486, respectively. In some example embodiments, each of the seventh and eighth contact plugs 474 and 476 may have a width that gradually decreases from a top to a bottom thereof in the third direction D3.

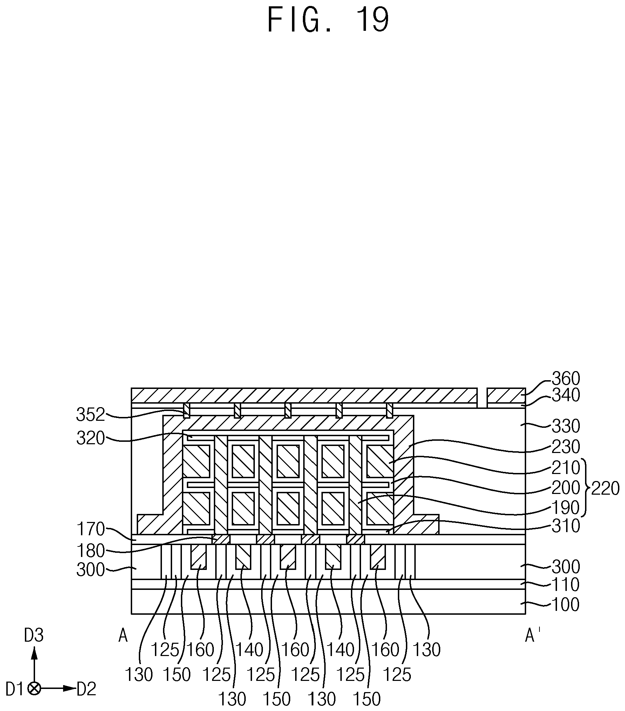

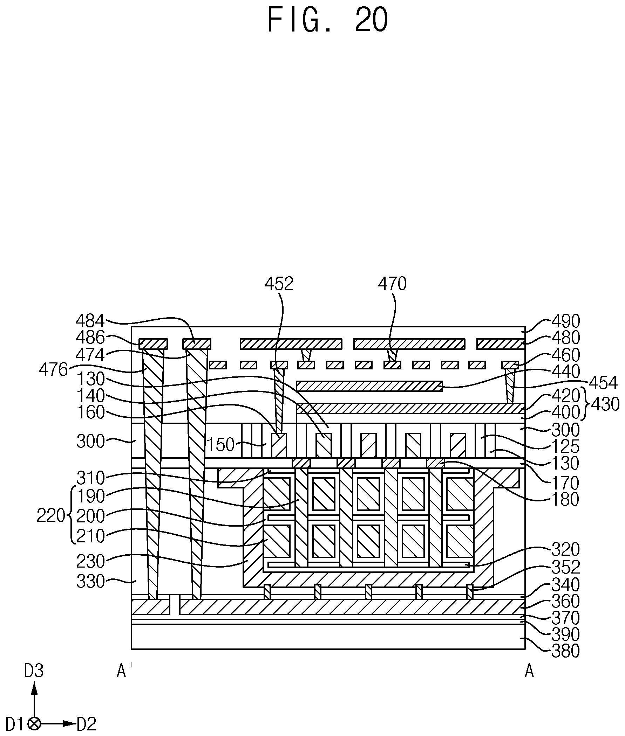

FIGS. 19 and 20 are cross-sectional views illustrating a method of manufacturing the semiconductor device of FIG. 18, according to an example embodiment. This method may include processes substantially the same as or similar to those illustrated with respect to FIGS. 3 to 14 and FIGS. 1 and 2, and thus repeated explanations are omitted herein.

Referring to FIG. 19, processes substantially the same as or similar to those illustrated with respect to FIGS. 3 to 9 may be performed.

However, the second and third conductive pads 184 and 186 may not be formed in the second insulating interlayer 170, and the second and third contact plugs 354 and 356 may not be formed in the third insulating interlayer 330.

Referring to FIG. 20, processes substantially the same as or similar to those illustrated with respect to FIGS. 10 to 12 may be performed.

However, the seventh and eighth contact plugs 474 and 476 may extend through not only the fifth insulating interlayer 490 but also the second etch stop layer 340, and may contact the first wiring 360. In some example embodiments, each of the seventh and eighth contact plugs 474 and 476 may have a width that gradually decreases from a top to a bottom thereof in the third direction D3.

Referring to FIG. 18 again, processes substantially the same as or similar to those illustrated with respect to FIGS. 13 and 14 and FIGS. 1 and 2 may be performed, so that the fabrication of the semiconductor device may be completed.

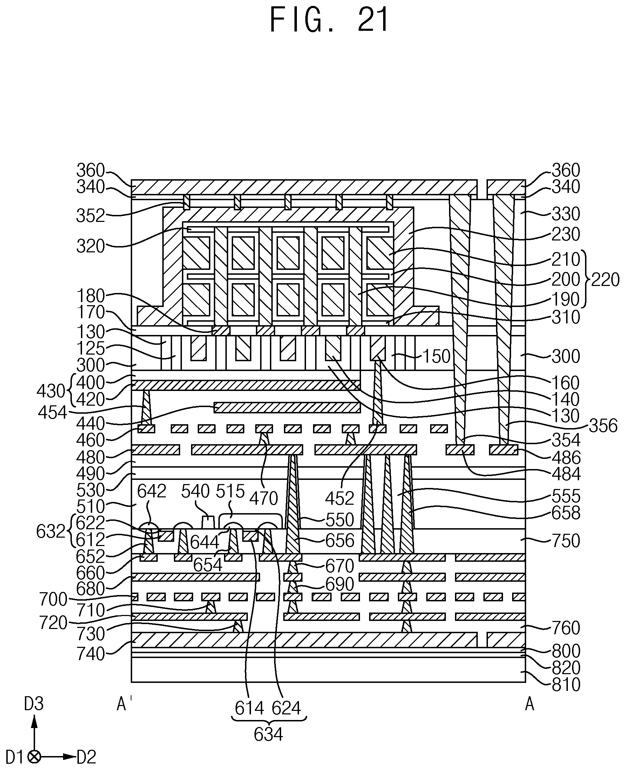

FIG. 21 is a cross-sectional view illustrating a semiconductor device in accordance with an example embodiment. This semiconductor device may be substantially the same as or similar to that of FIGS. 1 and 2 except for some elements, and thus repeated explanations are omitted herein.

Referring to FIG. 21, the second and third conductive pads 184 and 186 may not be formed in the second insulating interlayer 170, and the second and third contact plugs 354 and 356 may not be formed in the third insulating interlayer 330.

The second and third contact plugs 354 and 356 may extend through the second etch stop layer 340, the third insulating interlayer 330, the second insulating interlayer 170 and the upper portion of the fifth insulating interlayer 490, and may contact upper surfaces of the fifth and sixth wirings 484 and 486, respectively. The second and third contact plugs 354 and 356 may also contact the lower surface of the first wiring 360.

In some example embodiments, each of the second and third contact plugs 354 and 356 may have a width that gradually decreases from a top to a bottom thereof in the third direction D3.

The semiconductor device may have a COP structure in which the peripheral circuit region is disposed under the cell array region. The first plate electrode 230 may be arranged to face upwardly in the third direction D3, and the first and second transistors may be arranged under the third substrate 510 to face downwardly in the third direction D3.

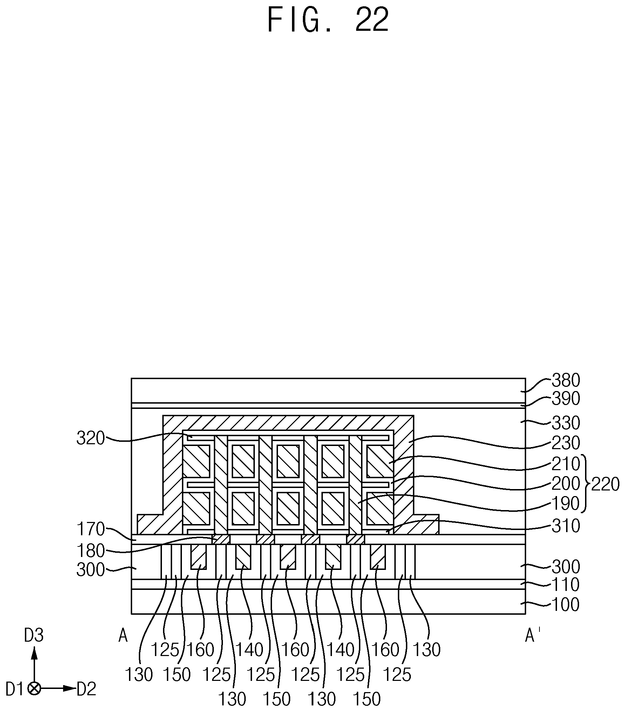

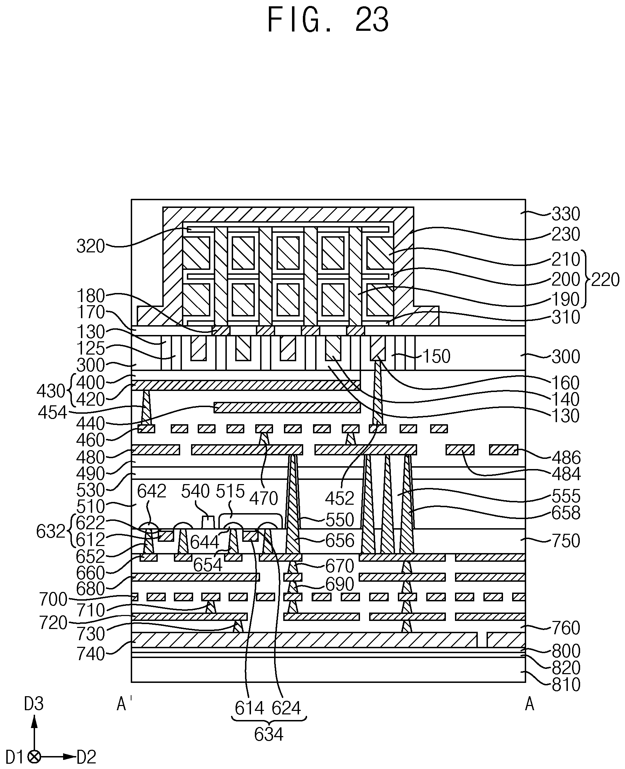

FIGS. 22 and 23 are cross-sectional views illustrating a method of manufacturing the semiconductor device of FIG. 21, according to an example embodiment. This method may include processes substantially the same as or similar to those illustrated with respect to FIGS. 3 to 14 and FIGS. 1 and 2, and thus repeated explanations are omitted herein.

Referring to FIG. 22, processes substantially the same as or similar to those illustrated with respect to FIGS. 3 to 8 may be performed.

However, the second and third conductive pads 184 and 186 may not be formed in the second insulating interlayer 170.

The third insulating interlayer 330 may be formed on the second insulating interlayer 170 to cover the plate electrode 230, and the second substrate 380 may be bonded to the upper surface of the third insulating interlayer 330 via the first bonding layer 390 therebetween.

Referring to FIG. 23, processes substantially the same as or similar to those illustrated with respect to FIGS. 10 to 14 and FIGS. 1 and 2 may be performed, however, the sixth and seventh contact plugs 474 and 476 may not be formed.

The eighth insulating interlayer 800 may be formed on the seventh insulating interlayer 760 and the eleventh wiring 740, and the fourth substrate 810 may be bonded to an upper surface of the eighth insulating interlayer 800 via the third bonding layer 820 therebetween.

The second substrate 380 may be flipped, the second substrate 380 and the first bonding layer 390 may be removed, and the upper surface of the third insulating interlayer 330 may be exposed.

Referring to FIG. 21 again, the second etch stop layer 340 may be formed on the third insulating interlayer 330, the first contact plug 352 extending through the second etch stop layer 340 to contact the upper surface of the first plate electrode 230, and the second and third contact plugs 354 and 356 extending through the second etch stop layer 340, the third insulating interlayer 330, the second insulating interlayer 170, and the upper portion of the fifth insulating interlayer 490 to contact the upper surfaces of the fifth and sixth wirings 484 and 486, respectively, may be formed.

In some example embodiments, each of the second and third contact plugs 354 and 356 may have a width that gradually decreases from a top to a bottom thereof in the third direction D3

The first wiring layer may be formed on the second etch stop layer 340 and the first to third contact plugs 352, 354 and 356, and may be partially etched to form a first wiring 360. The second etch stop layer 340 may also be partially etched so that a portion of the upper surface of the third insulating interlayer 330 may be exposed.

The fabrication of the semiconductor device may be completed by the above processes.

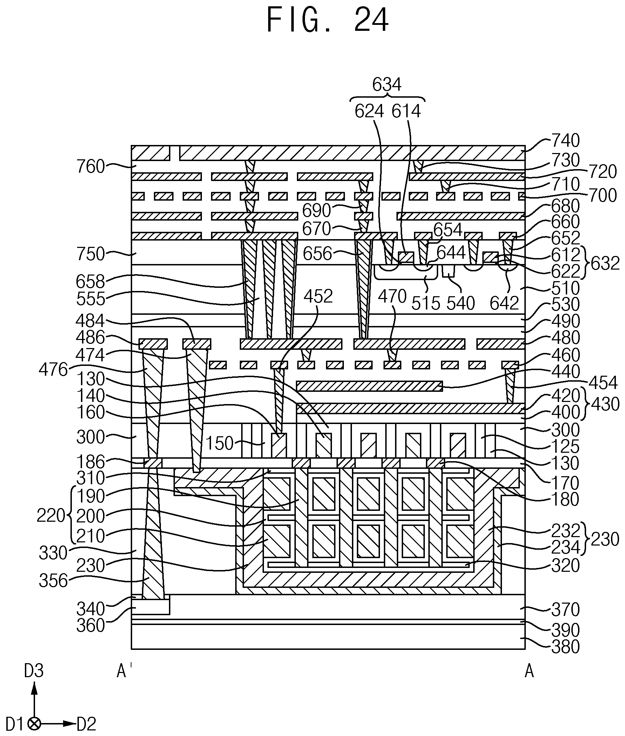

FIGS. 24 to 26 are cross-sectional views illustrating semiconductor devices, respectively, in accordance with some example embodiments. These semiconductor devices may be substantially the same as or similar to that of FIGS. 1 and 2 except for some elements, and thus repeated explanations are omitted herein.

Referring to FIG. 24, the first plate electrode 230 may include fifth and sixth conductive patterns 232 and 234 sequentially stacked, and each of the fifth and sixth conductive patterns 232 and 234 may include, for example, doped silicon-germanium and metal (e.g., tungsten), respectively.

In some example embodiments, the first contact plug 352 may not be disposed between the first plate electrode 230 and the first wiring 360, and thus may not be electrically connected to the first wiring 360. The second conductive pad 184 may not be disposed in the second insulating interlayer 170.

In some example embodiments, the sixth contact plug 474 may extend through not only the fifth insulating interlayer 490, but also the second insulating interlayer 170, and may contact the fifth conductive pattern 232 in the first plate electrode 230 to be electrically connected to the fifth conductive pattern 232. Thus, the first plate electrode 230 may be electrically connected to the fifth wiring 484 via the sixth contact plug 474.

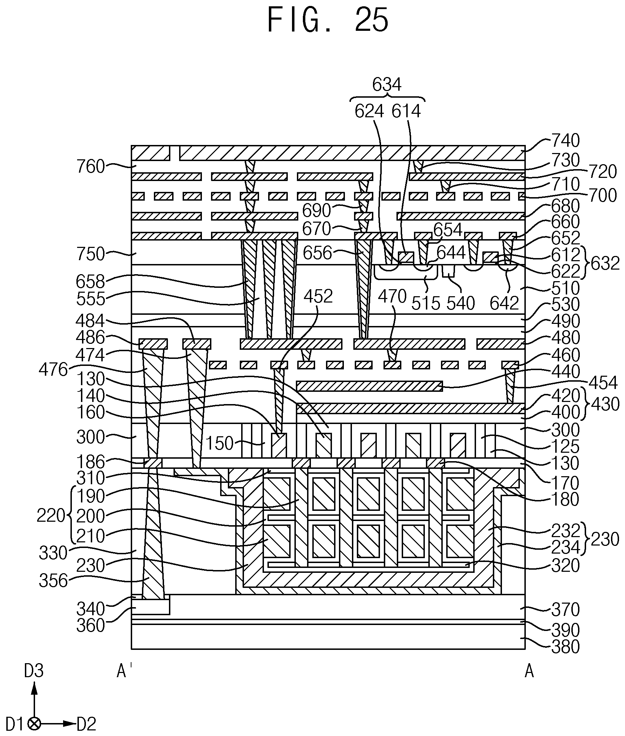

Referring to FIG. 25, similarly to the semiconductor device illustrated in FIG. 24, the first plate electrode 230 may include the fifth and sixth conductive patterns 232 and 234 sequentially stacked, and the first contact plug 352 and the second conductive pad 184 may not be formed.

However, the sixth contact plug 474 may contact the sixth conductive pattern 234, which may be included in the first plate electrode 230, and may be electrically connected to the sixth conductive pattern 234. Thus, the first plate electrode 230 may be electrically connected to the fifth wiring 484 via the sixth contact plug 474.

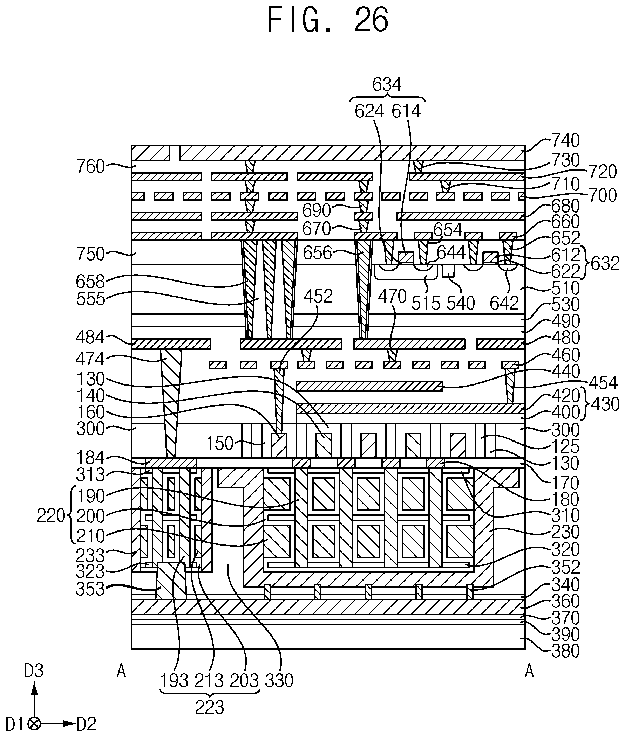

Referring to FIG. 26, a fourteenth contact plug 353, a dummy capacitor 223, and a dummy plate electrode 233, instead of the second contact plug 354, may be disposed between the first wiring 360 and the second conductive pad 184 to electrically connect the first wiring 360 and the second conductive pad 184 to each other.

The dummy capacitor 223 may include a first dummy capacitor electrode 193, a dummy dielectric layer 203 and a second dummy capacitor electrode 213, and a dummy etch stop layer 313 and a dummy support layer may be disposed on a sidewall of the first dummy capacitor electrode 193. A dummy plate electrode 233 may be disposed on a sidewall of the dummy capacitor 223.

The fourteenth contact plug 353 may extend through the third insulating interlayer 330 and the second etch stop layer 340, and may contact the upper surface of the first wiring 360 and the first dummy capacitor electrode 193 included in the dummy capacitor 223.

The dummy capacitor 223 and the dummy plate electrode 233 may be formed when the first capacitor 220 and the first plate electrode 230 are formed, and the fourteenth contact plug 353 may be formed when the first contact plug 352 is formed.

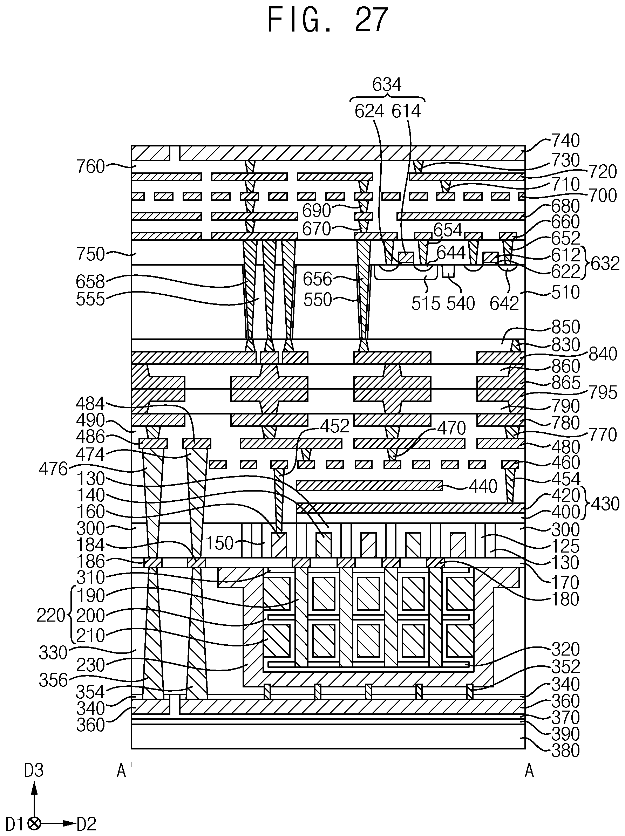

FIG. 27 is a cross-sectional view illustrating a semiconductor device in accordance with an example embodiment. This semiconductor device may be substantially the same as or similar to that of FIGS. 1 and 2 except for some elements, and thus repeated explanations are omitted herein.

Referring to FIG. 27, a third via 770 contacting the upper surface of the fourth wiring 480 and a twelfth wiring 780 contacting an upper surface of the third via 770 may be disposed in the fifth insulating interlayer 490. A fourth via 830 contacting a lower surface of each of the first and second through vias 656 and 658, a thirteenth wiring 840 contacting a lower surface of the fourth via 830, and a ninth insulating interlayer 850 covering the fourth via 830 and the thirteenth wiring 840 may be disposed under the first region 510 of the third substrate structure 500.

A fourth bonding layer 790 may be disposed on the fifth insulating interlayer 490 and the twelfth wiring 780, and a first bonding pattern 795 may extend through the fourth bonding layer 790 and contact an upper surface of the twelfth wiring 780. A fifth bonding layer 860 may be disposed under the ninth insulating interlayer 850 and the thirteenth wiring 840, and a second bonding pattern 865 may extend through the fifth bonding layer 860.

In some example embodiments, a plurality of first bonding patterns 795 may be spaced apart from each other in the horizontal direction, and a plurality of second bonding patterns 865 may be spaced apart from each other in the horizontal direction. The fourth and fifth bonding layers 790 and 860 may be bonded to each other to form a bonding layer structure, and the first and second bonding patterns 795 and 865 may be bonded to each other to form a bonding pattern structure.

Each of the fourth and fifth bonding layers 790 and 860 may include oxide (e.g., silicon oxide), and each of the first and second bonding patterns 795 and 865 may include metal (e.g., copper).

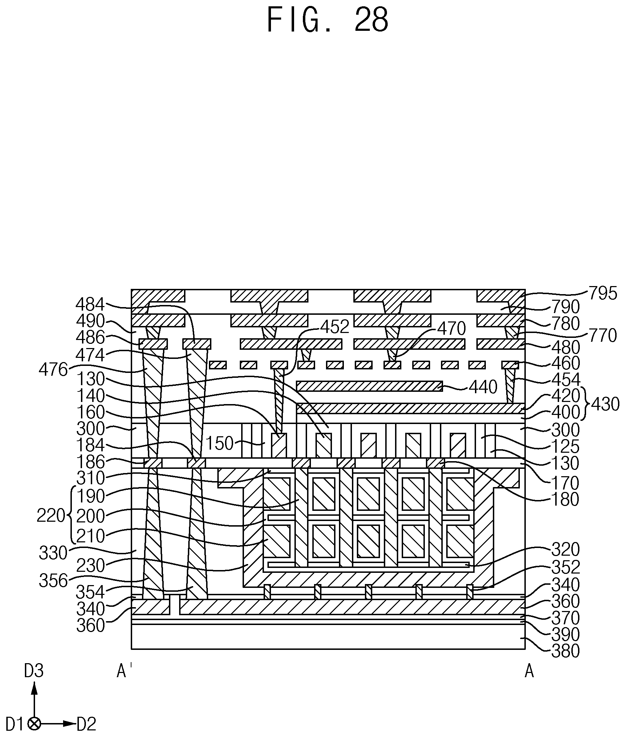

FIG. 28 is a cross-sectional view illustrating a method of manufacturing the semiconductor device of FIG. 27 in accordance with an example embodiment. This method may include processes substantially the same as or similar to those illustrated with respect to FIGS. 3 to 14 and FIGS. 1 and 2, and thus repeated explanations are omitted herein.

Referring to FIG. 28, processes substantially the same as or similar to those illustrated with respect to FIGS. 3 to 12 may be performed.

However, a third via 770 may be further formed in the fifth insulating interlayer 490 to contact the upper surface of the fourth wiring 480, and a twelfth wiring 780 may be further formed to contact an upper surface of the third via 770.

A fourth bonding layer 790 may be formed on the fifth insulating interlayer 490 and the twelfth wiring 780, and a first bonding pattern 795 may be formed through the fourth bonding layer 790 to contact an upper surface of the twelfth wiring 780.

Referring to FIG. 27 again, processes substantially the same as or similar to those illustrated with respect to FIGS. 13 and 14 and FIGS. 1 and 2 may be performed.

However, a fourth via 830 and a thirteenth wiring 840 may be formed under the first region 510 of the third substrate structure 500, and a ninth insulating interlayer 850 may be formed to cover the fourth via 830 and the thirteenth wiring 840. A fifth bonding layer 860 may be formed under the ninth insulating interlayer 850, and a second bonding pattern 865 may be formed through the fifth bonding layer 860.

That is, the fourth and fifth bonding layers 790 and 860 may bonded to each other by a hybrid copper bonding (HCB), and the first and second bonding patterns 795 and 865 may contact and be bonded to each other.

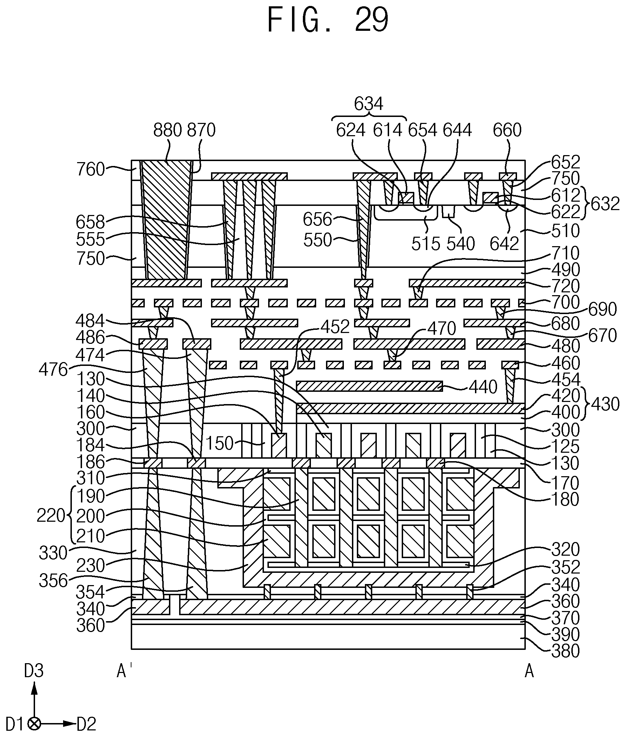

FIG. 29 is a cross-sectional view illustrating a semiconductor device in accordance with example embodiments. This semiconductor device may be substantially the same as or similar to that of FIGS. 1 and 2 except for some elements, and thus repeated explanations are omitted herein.

Referring to FIG. 29, the power line included in the semiconductor device may be disposed under the third substrate 510.

Thus, e.g., the tenth to twelfth contact plugs 670, 690 and 710 and the eighth to tenth wirings 680, 700 and 720 may be disposed under the third substrate 510, and covered by the fifth insulating interlayer 490.

A third through via 880 may extend through the sixth and seventh insulating interlayers 750 and 760, the third substrate 510, and the upper portion of the fifth insulating interlayer 490, and may contact an upper surface of the tenth wiring 720. A third insulation patten 870 may cover a sidewall of the third through via 880. Power may be transferred to the memory cells and the periphery circuit pattern through the third through via 880 and the power line electrically connected to the third through via 880.

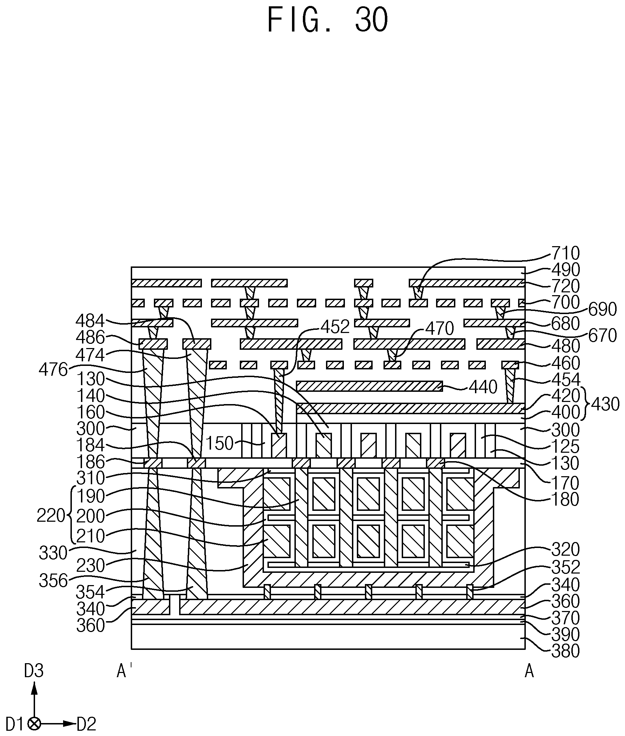

FIG. 30 is a cross-sectional view illustrating a method of manufacturing the semiconductor device of FIG. 29 in accordance with an example embodiment. This method may include processes substantially the same as or similar to those illustrated with respect to FIGS. 3 to 14 and FIGS. 1 and 2, and thus repeated explanations are omitted herein.

Referring to FIG. 30, processes substantially the same as or similar to those illustrated with respect to FIGS. 3 to 12 may be performed.

However, the tenth to twelfth contact plugs 670, 690 and 710 and the eighth to tenth wirings 680, 700 and 720 contacting the upper surface of the fourth wiring 480, that is, a portion of the wiring structure included in the power line may be further formed, and may be covered by the fifth insulating interlayer 490.

Referring to FIG. 29 again, processes substantially the same as or similar to those illustrated with respect to FIGS. 13 and 14 and FIGS. 1 and 2 may be performed, however, the power line already formed in the fifth insulating interlayer 490, the second via 730 and the eleventh wiring 740 may not be formed.

The third through via 880 may be further formed through the sixth and seventh insulating interlayers 750 and 760, the third substrate 510, and the upper portion of the fifth insulating interlayer 490 to contact an upper surface of the tenth wiring 720, and the third insulation patten 870 may be further formed to cover a sidewall of the third through via 880, so that the fabrication of the semiconductor device may be completed.

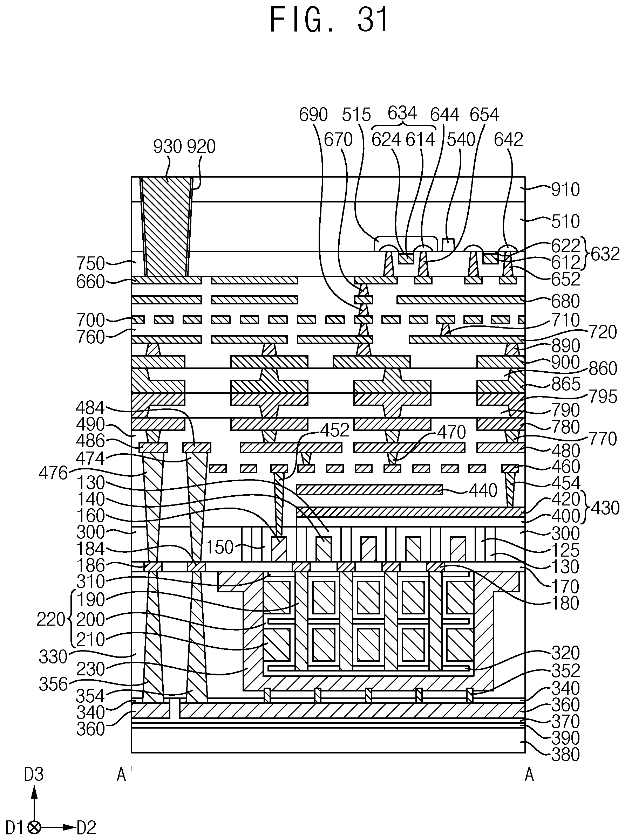

FIG. 31 is a cross-sectional view illustrating a semiconductor device in accordance with an example embodiment. This semiconductor device may be substantially the same as or similar to that of FIG. 27 except for some elements, and thus repeated explanations are omitted herein.

Referring to FIG. 31, unlike the semiconductor device of FIG. 27, each of the first and second transistors included in the periphery circuit may face downwardly in the third direction D3 under the third substrate 510, so that the signal line and the power line electrically connected to the first and second transistors may be disposed under the third substrate 510.

The first and second insulation patterns 550 and 555 extending through the third substrate 510, the first and second through vias 656 and 658 extending through the sixth insulating interlayer 750 and the third substrate 510, and the second via 730 and the eleventh wiring 740 may not be formed.

However, a fifth via 890 and a fourteenth wiring 900 may be disposed under the tenth wiring 720. Additionally, the fifth bonding layer 860 and the second bonding pattern 865 may be disposed under the seventh insulating interlayer 760 and the fourteenth wiring 900, and may be bonded to the fourth bonding layer 790 and the first bonding pattern 795.

A tenth insulating interlayer 910 may be disposed on the third substrate 510. Additionally, a fourth through via 930 may extend through the tenth insulating interlayer 910, the third substrate 510 and the sixth insulating interlayer 750, and may contact the seventh wiring 660. A fourth insulation pattern 920 may cover a sidewall of the fourth through via 930. Thus, the power may be transferred to the memory cells and the periphery circuit pattern through the fourth through via 930 and the power line electrically connected to the fourth through via 930.

However, in some example embodiments, the power line may be disposed on the third substrate 510.

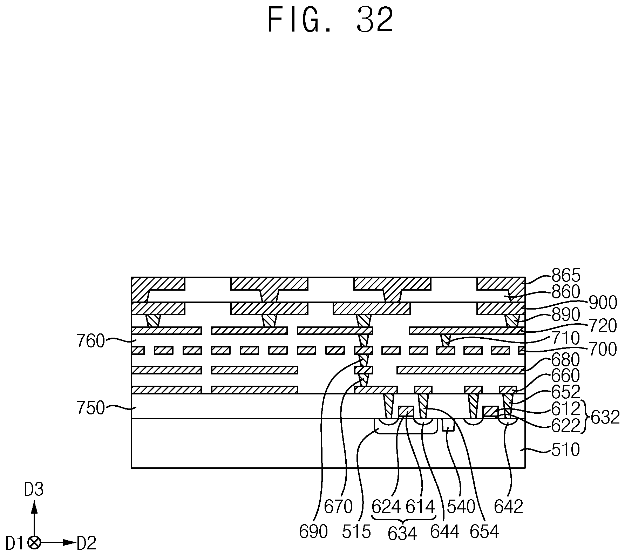

FIG. 32 is a cross-sectional view illustrating a method of manufacturing the semiconductor device of FIG. 31 in accordance with an example embodiment. This method may include processes substantially the same as or similar to those illustrated with respect to FIGS. 3 to 14 and FIGS. 1 and 2, or FIGS. 28 and 27, and thus repeated explanations are omitted herein.

Referring to FIG. 32, processes substantially the same as or similar to those illustrated with respect to FIG. 28 may be performed, and processes substantially the same as or similar to those illustrated with respect to FIG. 1 may be performed.

However, the first and second insulation patterns 550 and 555 extending through the third substrate 510, the first and second vias 656 and 658 extending through the sixth insulating interlayer 750 and the third substrate 510, the second via 730 and the eleventh wiring 740 may not be formed.

A fifth via 890 and a fourteenth wiring 900 may further formed on the tenth wiring 720, and a fifth bonding layer 860 and a second bonding pattern 865 extending through the fifth bonding layer 860 may be further formed on the seventh insulating interlayer 760 and the fourteenth wiring 900.

Referring to FIG. 31 again, the third substrate 510 may be flipped, and the fifth bonding layer 860 may be bonded to the fourth bonding layer 790, and the second bonding pattern 865 may be bonded to the first bonding pattern 795.

A tenth insulating interlayer 910 may be formed on the third substrate 510, a fourth through via 930 may be formed through the tenth insulating interlayer 910, the third substrate 510 and the sixth insulating interlayer 750 to contact the seventh wiring 660, and a fourth insulation pattern 920 may be formed to cover the fourth through via 930, so that the fabrication of the semiconductor device may be completed.

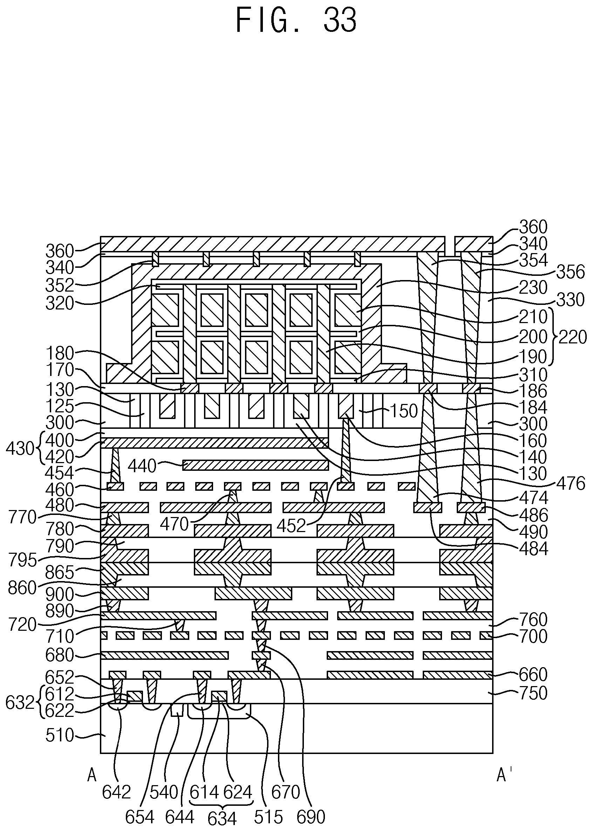

FIG. 33 is a cross-sectional view illustrating a semiconductor device in accordance with example embodiments. This semiconductor device may be substantially the same as or similar to that of FIG. 31 except for some elements, and thus repeated explanations are omitted herein.

Referring to FIG. 33, unlike the semiconductor device of FIG. 31, the semiconductor device may have the COP structure.

Thus, the semiconductor device of FIG. 33 may have a structure similar to a structure of the semiconductor device of FIG. 31 but flipped. However, the tenth insulating interlayer 910 may not be formed under the third substrate 510, and the fourth through via 930 and the fourth insulation pattern 920 may not be formed.

The fourth insulating interlayer 370, the first bonding layer 390, and the second substrate 380 may not be formed on the first wiring 360.

In the semiconductor device, the first plate electrode 230 in the cell array region may be arranged to face upwardly in the third direction D3, and each of the first and second transistors in the periphery circuit region may be arranged to face upward in the third direction D3.

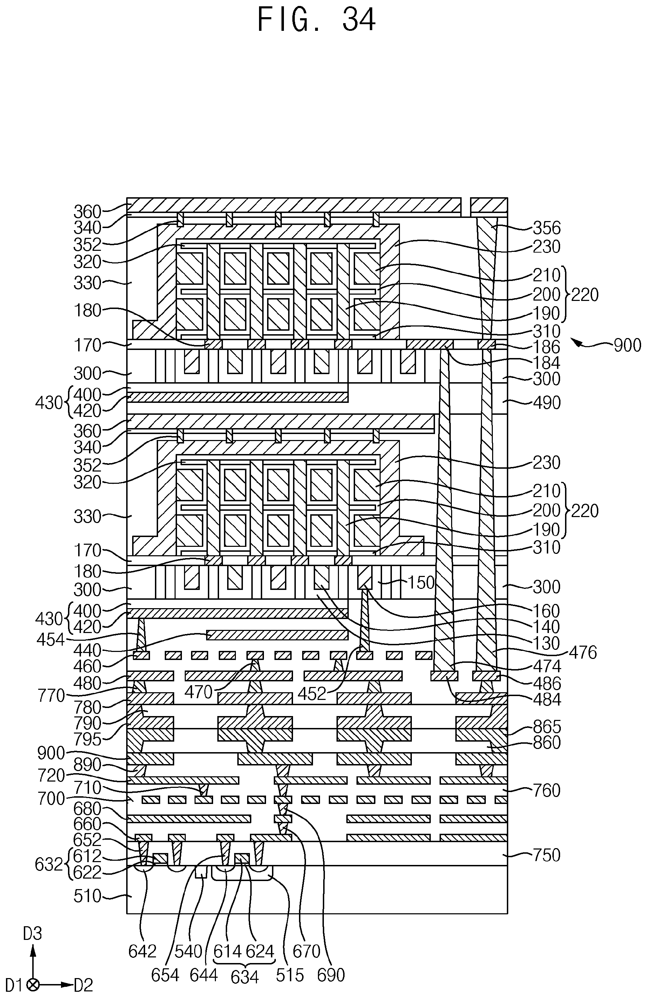

FIG. 34 is a cross-sectional view illustrating a semiconductor device in accordance with example embodiments. This semiconductor device may be substantially the same as or similar to that of FIG. 33 except for some elements, and thus repeated explanations are omitted herein.

Referring to FIG. 34, the semiconductor device may have the COP structure, similar to the semiconductor device of FIG. 33, however, unlike that of FIG. 33, the cell array regions may be arranged at two levels, on the periphery circuit region.

The first plate electrode in each of the cell array regions may be arranged to face upwardly in the third direction D3, and each of the first and second transistors in the periphery circuit region may be arranged on the third substrate 510 to face upwardly in the third direction D3.

In some example embodiments, the second contact plug 354 may not be formed in the third insulating interlayer 330, which may cover the first plate electrode 230 in an upper one of the cell array regions, and the second conductive pad 184 in the second insulating interlayer 170 under the third insulating interlayer 330 may contact an upper surface of the first gate electrode 140. However, the inventive concepts are not limited thereto, and in some embodiments, the second conductive pad 184 may contact an upper surface of the second gate electrode 160.

In some example embodiments, the seventh and eighth contact plugs 474 and 476 may extend through the fifth insulating interlayer 490, the first insulating interlayer 300, the second insulating interlayer 170, the third insulating interlayer 330, the fifth insulating interlayer 490 and the first insulating interlayer 300 sequentially stacked upwardly in the third direction D3, and may contact lower surfaces of the second and third conductive pads 184 and 186, respectively. Thus, the first gate electrode 140 in the upper one of the cell array regions, or the second gate electrode 160 may be electrically connected to the fifth wiring 484 through the second conductive pad 184 and the seventh contact plug 474.

In some example embodiments, a contact plug may contact the first bit line structure 430 in the upper one of the cell array regions and the fourth wiring 480, and may be electrically connected to the first bit line structure 430 and the fourth wiring 480.

In some example embodiments, each of the seventh and eighth contact plugs 474 and 476 may have a width that gradually decreases from a bottom to a top thereof in the third direction D3.

Referring to FIG. 34, the cell array regions are arranged at two levels, on the periphery circuit region, however, the inventive concepts are not limited thereto, and may be arranged at more than two levels.

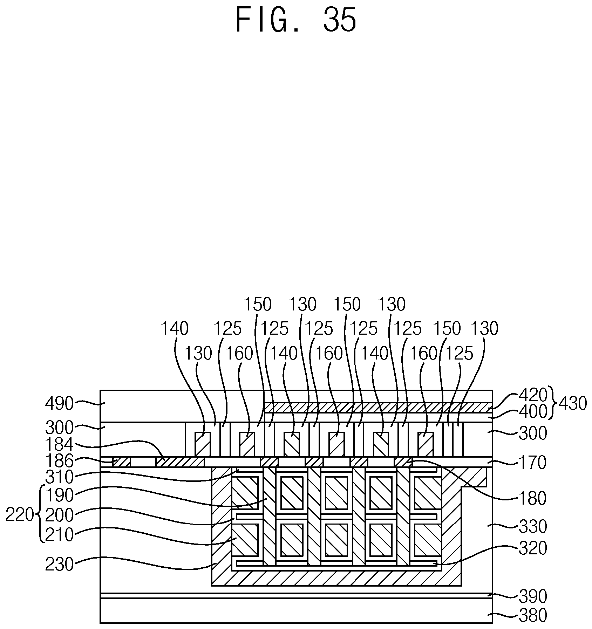

FIGS. 35 to 40 are cross-sectional views illustrating a method of manufacturing the semiconductor device of FIG. 34 in accordance with an example embodiment. This method may include processes substantially the same as or similar to those illustrated with respect to FIGS. 3 to 14 and FIGS. 1 and 2, or FIGS. 32 and 31, and thus repeated explanations are omitted herein.

Referring to FIG. 35, processes substantially the same as or similar to those illustrated with respect to FIGS. 3 to 11 may be performed, the first bit line structure 430 may be formed, and the fifth insulating interlayer 490 may be formed to cover the first bit line structure 430.

However, the second etch stop layer 340, the first wiring 360, the first to third contact plugs 352, 354 and 356, and the fourth insulating interlayer 370 may not be formed.

In some example embodiments, the second conductive pad 184 may contact a lower surface of the first gate electrode 140 to electrically connected to the first gate electrode 140. In some example embodiments, the second conductive pad 184 may contact a lower surface of the second gate electrode 160 to electrically connected to the second gate electrode 160.

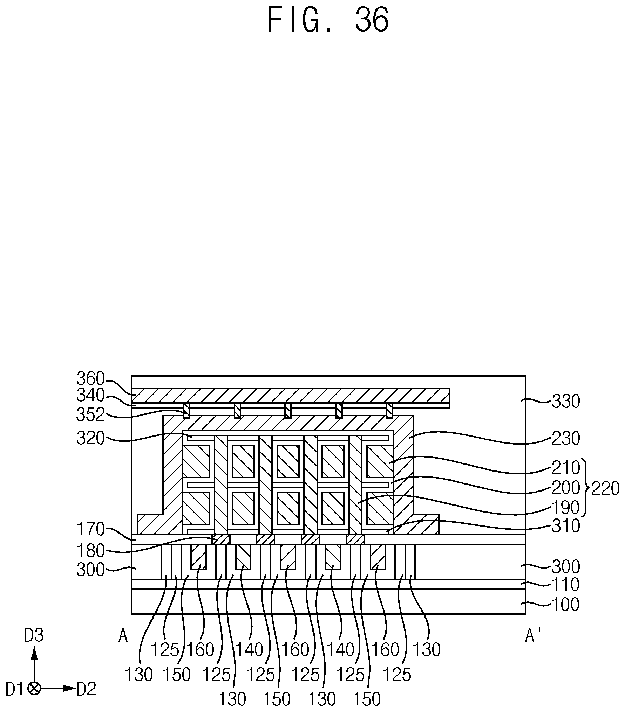

Referring to FIG. 36, processes substantially the same as or similar to those illustrated with respect to FIGS. 3 to 9 may be performed.

However, the second and third conductive pads 184 and 186 and the second and third contact plugs 354 and 356 may not be formed.

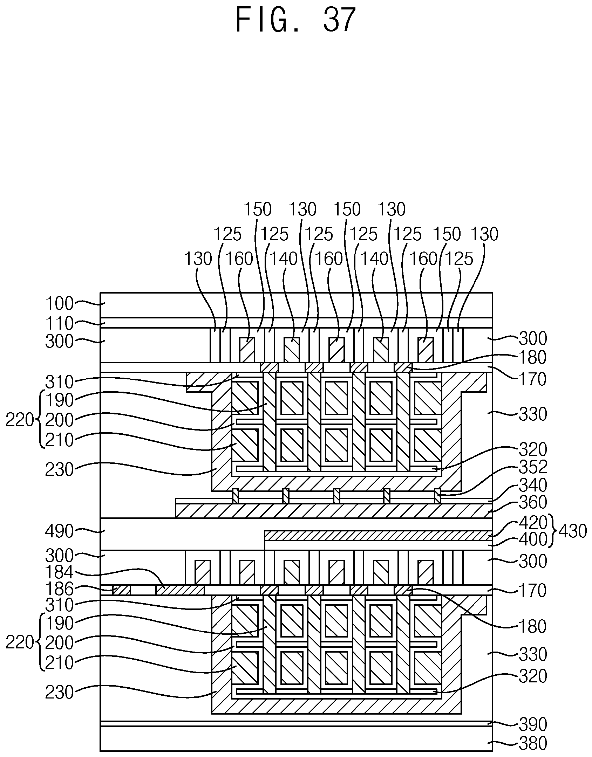

Referring to FIG. 37, the first bulk substrate 100 of FIG. 36 may be flipped, and the third insulating interlayer 330 may contact the upper surface of the fifth insulating interlayer 490 to be bonded thereto.

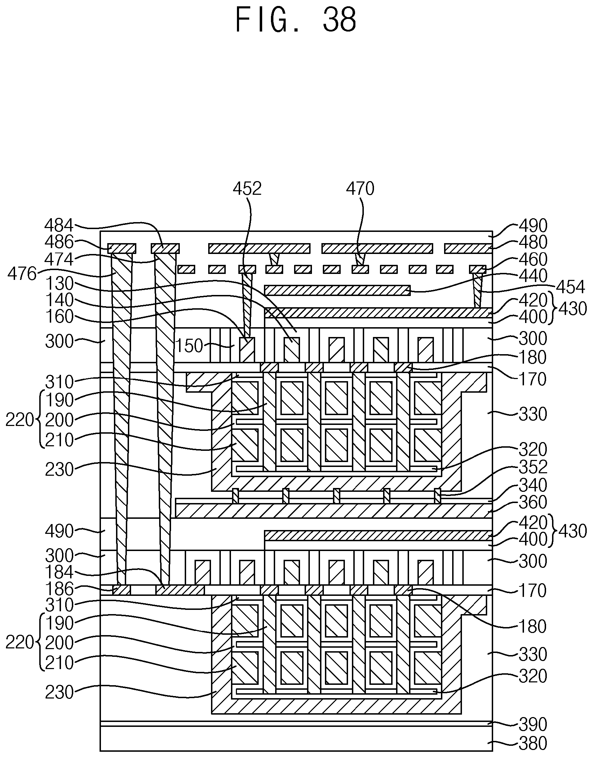

Referring to FIG. 38, processes substantially the same as or similar to those illustrated with respect to FIGS. 11 to 12 may be performed.

However, the seventh and eighth contact plugs 474 and 476 may extend through not only the fifth insulating interlayer 490, but also the first insulating interlayer 300, the second insulating interlayer 170, the third insulating interlayer 330, the fifth insulating interlayer 490 and the first insulating interlayer 300 sequentially stacked downwardly in the third direction D3 to contact the upper surfaces of the second and third conductive pads 184 and 186, respectively.

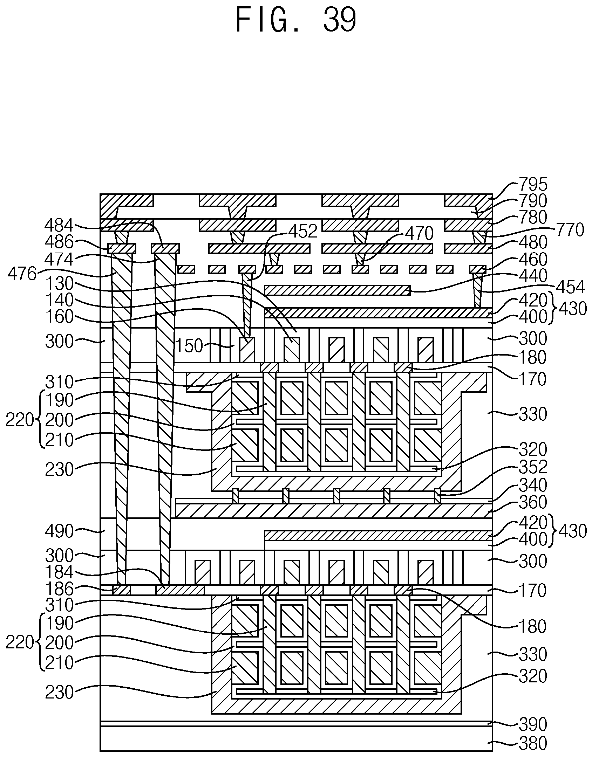

Referring to FIG. 39, the third via 770 may be formed through the upper portion of the fifth insulating interlayer 490 to contact the upper surfaces of the fourth to sixth wirings 480, 484 and 486, the twelfth wiring 780 may be formed to contact the upper surface of the third via 770, and the eleventh insulating interlayer may be formed on the fifth insulating interlayer 490 to cover a sidewall of the twelfth wiring 780.

In some example embodiments, the eleventh insulating interlayer may include a material substantially the same as that of the fifth insulating interlayer 490, and may be merged with the fifth insulating interlayer 490. Hereinafter, the fifth insulating interlayer 490 together with the eleventh insulating interlayer may be collectively referred to as the fifth insulating interlayer 490.

The fourth bonding layer 790 may be formed on the fifth insulating interlayer 490 and the twelfth wiring 780, and the first bonding pattern 795 may be formed through the fourth bonding layer 790. The first bonding pattern 795 may contact the upper surface of the twelfth wiring 780.

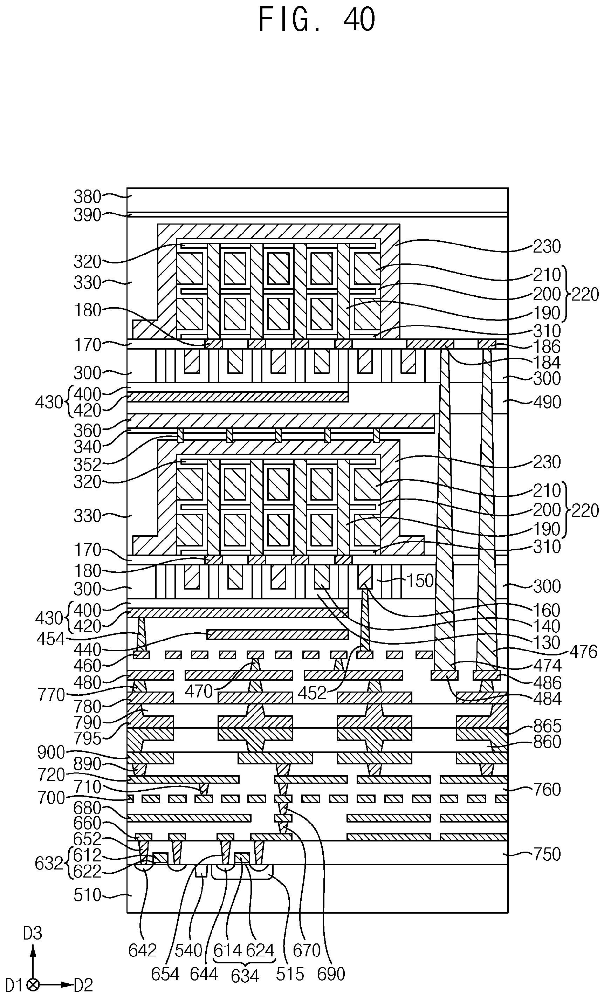

Referring to FIG. 40, processes substantially the same as or similar to those illustrated with respect to FIG. 32 may be performed to form the periphery circuit pattern, and the fifth bonding layer 860 and the second bonding pattern 865 extending through the fifth bonding layer 860, the second substrate 380 may be flipped, and the fourth bonding layer 790 and the first bonding pattern 795 may be bonded to the fifth bonding layer 860 and the second bonding pattern 865.

Referring to FIG. 34 again, the second etch stop layer 340 may be formed on the third insulating interlayer 330, and the first contact plug 352 extending through the second etch stop layer 349 to contact the upper surface of the first plate electrode 230 and the third contact plug 356 extending through the second etch stop layer 340 and the third insulating interlayer 330 to contact the upper surfaces of the third conductive pads 186, respectively, may be formed.

The first wiring 360 may be formed on the second etch stop layer 340 and the first and third contact plugs 352 and 356, so that the fabrication of the semiconductor device may be completed.

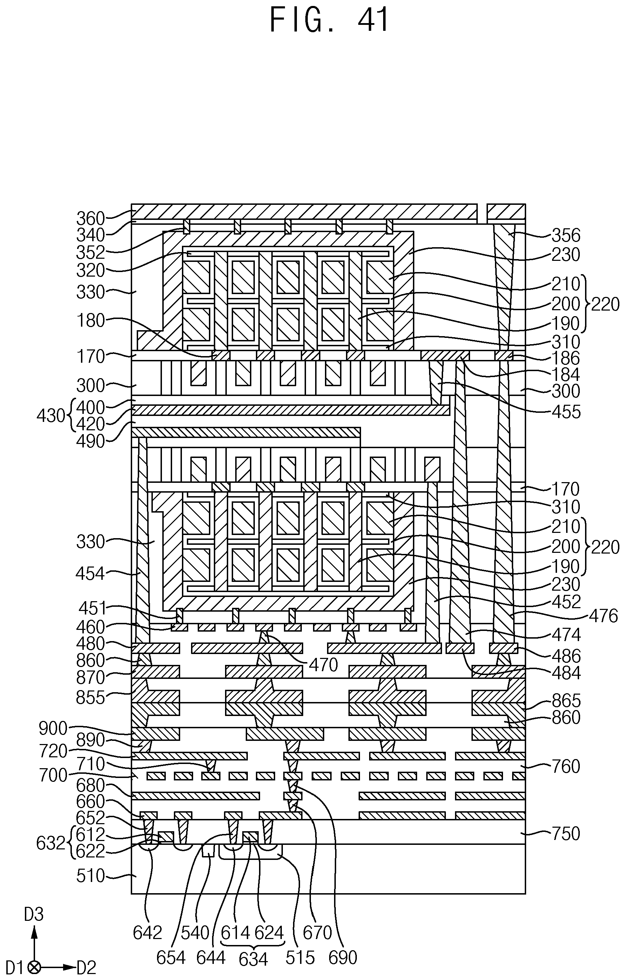

FIGS. 41 to 43 are cross-sectional views illustrating semiconductor devices in accordance with some example embodiments.

Each of the semiconductor devices may have the COP structure, in which the cell array regions are arranged at two levels on the periphery circuit region, and each of the first and second transistors in the periphery circuit region may be arranged to face upwardly in the third direction D3 on the third substrate 510, similar to the semiconductor device of FIG. 33. However, an orientation of the first plate electrodes 230 included in each of the semiconductor devices may be different from that of the first plate electrodes 230 of the semiconductor device of FIG. 34.

Referring to FIG. 41, the first plate electrode 230 in the upper one of the cell array regions may be arranged to face upwardly in the third direction D3, while the first plate electrode 230 in a lower one of the cell array regions may be arranged to face downwardly in the third direction D3.

In some example embodiments, the first plate electrode 230 in the lower one of the cell array regions may be electrically connected to the third wiring 460 through a fifteenth contact plug 451 extending through a portion of third insulating interlayer 330. The first gate electrode 140 or the second gate electrode 160 in the lower one of the cell array regions may be electrically connected to the fourth wiring 480 through the fourth contact plug 452 extending through the portion of the third insulating interlayer 330 and the second insulating interlayer 170. The first bit line structure 430 in the lower one of the cell array regions may be electrically connected to the fourth wiring 480 through the fifth contact plug 454 extending through the portion of the third insulating interlayer 330 and the first and second insulating interlayers 300 and 170.

In some example embodiments, each of the fourth and fifth contact plugs 452 and 454 may have a width that gradually decreases from a bottom to a top thereof in the third direction D3.

The first bit line structure 430 in the lower one of the cell array regions may be electrically connected to the fifth wiring 484 through a sixteenth contact plug, which may extend through the first insulating interlayer 300 to contact the lower surface of the second conductive pads 184, the second conductive pads 184 and the sixth contact plug 474.

In some example embodiments, a contact plug and a conductive pad may electrically connect the first gate electrode 140 or the second gate electrode 160 in the upper one of the cell array regions to a wiring at the same level as the fourth to sixth wirings 480, 484 and 486.

In some example embodiments, the sixteenth contact plug 455 may have a width that gradually increases from a bottom to a top thereof.

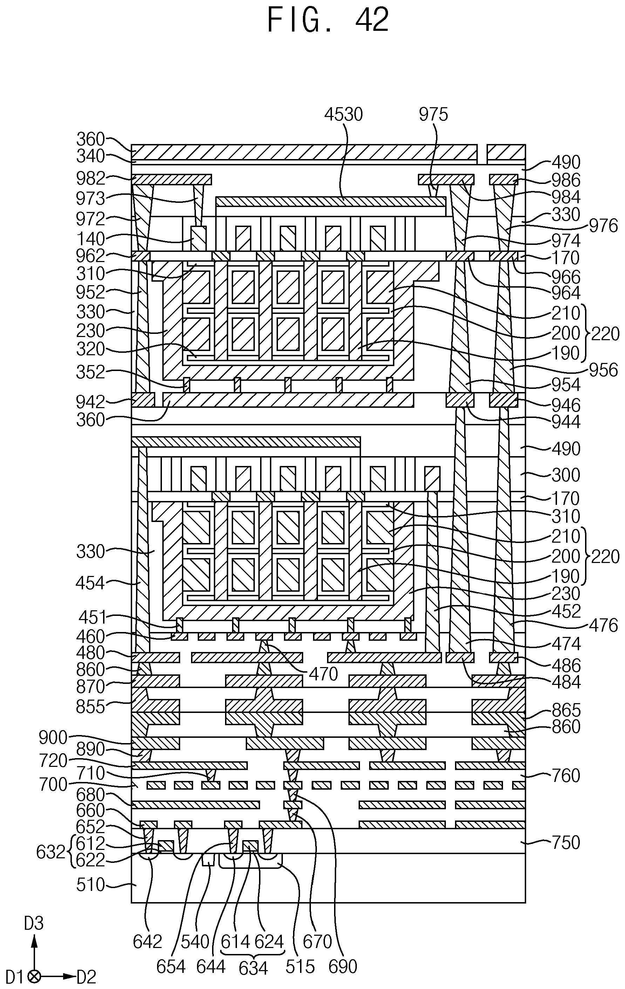

Referring to FIG. 42, the first plate electrode 230 in each of the lower and upper ones of the cell array regions may be arranged to face downwardly in the third direction D3.

In some example embodiments, the first plate electrode 230 in the upper one of the cell array regions may be electrically connected to the first wiring 360 under the first plate electrode 230, and a fifteenth wiring 942 and fourth and fifth conductive pads 944 and 946 may be disposed at the same level as the first wiring 360. Sixth to eighth conductive pads 962, 964 and 966 may be disposed in the second insulating interlayer 170 on the first plate electrode 230 in the upper one of the cell array regions, and sixteenth to eighteenth wirings 982, 984 and 986 may be formed in the fifth insulating interlayer 490 on the second insulating interlayer 170.

In some example embodiments, a seventeenth contact plug 952 may be disposed between the fifteenth wiring 942 and the sixth conductive pads 962, an eighteenth contact plug 954 may be disposed between the fourth conductive pad 944 and the seventh conductive pads 964, and a nineteenth contact plug 956 may be disposed between the fifth conductive pad 946 and the eighth conductive pad 966.

A twentieth contact plug 972 may be disposed between the sixth conductive pad 962 and the sixteenth siring 982, a twenty-first contact plug 973 may be disposed between the sixteenth wiring 982 and the first gate electrode 140 or the second gate electrode 160, a twenty-second contact plug 974 may be disposed between the seventh conductive pad 964 and the seventeenth wiring 984, a twenty-third contact plug 975 may be disposed between the seventeenth wiring 984 and the first bit line structure 430, and a twenty-fourth contact plug 976 may be disposed between the eighth conductive pad 966 and the eighteenth wiring 986.

Thus, the first gate electrode 140 or the second gate electrode 160 in the upper one of the cell array regions may be electrically connected to the fifteenth wiring 942 through the twenty-first contact plug 973, the sixteenth wiring 982, the twentieth contact plug 972, the sixth conductive pad 962, and the seventeenth contact plug 952. The first bit line structure 430 in the upper one of the cell array regions may be electrically connected to the fifth wiring 484 through the twenty-third contact plug 975, the seventeenth wiring 984, the twenty-second contact plug 974, the seventh conductive pad 964, the eighteenth conductive plug 954, the fourth conductive pad 944 and the sixth contact plug 474. The eighteenth wiring 986 may be electrically connected to the sixth wiring 486 through the twenty-fourth contact plug 976, the eighth conductive pad 966, the nineteenth contact plug 956, the fifth conductive pad 946 and the seventh contact plug 476.

In some example embodiments, each of the seventeenth to nineteenth contact plugs 952, 954 and 956 may have a width that gradually decreases from a bottom to a top thereof, and each of the twentieth to twenty fourth contact plugs 972, 973, 974, 975 and 976 may have a width that gradually increases from a bottom to a top thereof.

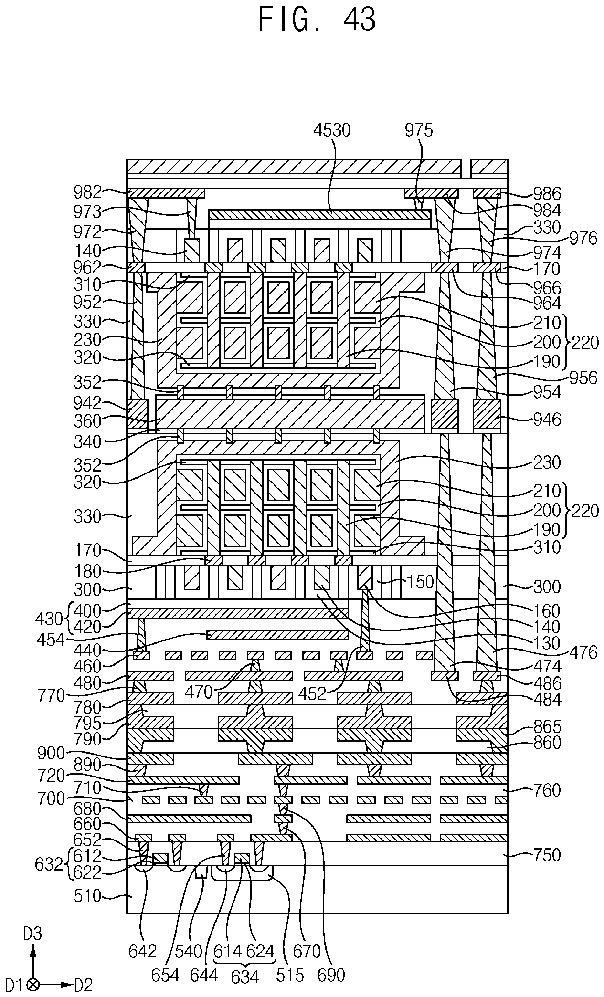

Referring to FIG. 43, the first plate electrode 230 in the upper one of the cell array regions may be arranged to face downwardly in the third direction D3, while the first plate electrode 230 in the lower one of the cell array regions may be arranged to face upwardly in the third direction D3.

The semiconductor device may be similar to that of FIG. 42, however, the first plate electrode 230 in the lower one of the cell array regions and the first plate electrode 230 in the upper one of the cell array regions may be commonly and electrically connected to the first wiring 360 between the first plate electrodes 230. The fifteenth wiring 942 and the fourth and fifth conductive pads 944 and 946 may be disposed at the same level as the first wiring 360.

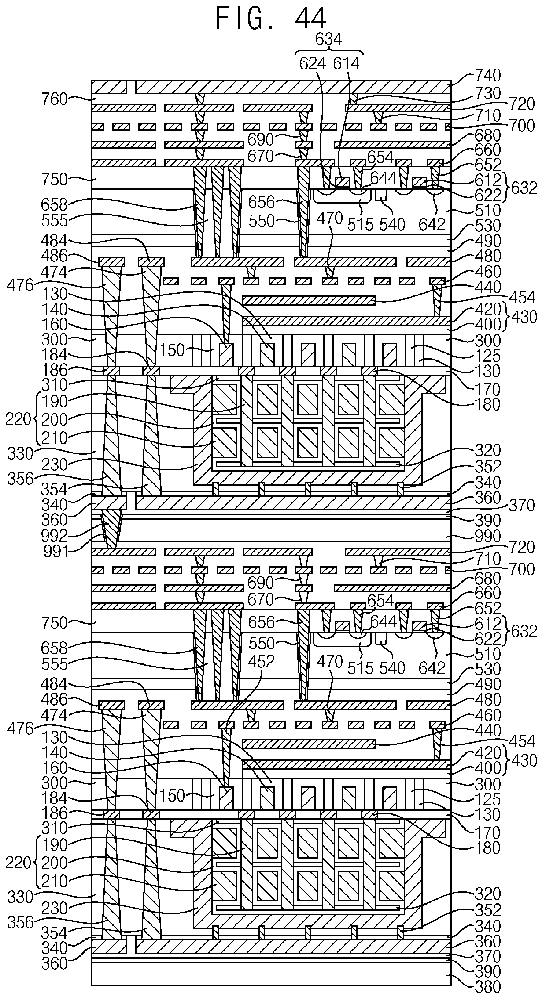

FIG. 44 is a cross-sectional view illustrating a semiconductor device stack structure in accordance with an example embodiment.

The semiconductor device stack structure may be manufactured by stacking the semiconductor devices of FIG. 1 in the third direction D3 with a fifth substrate 990 therebetween, and FIG. 44 shows that the semiconductor device stack structure includes two semiconductor devices of FIG. 1 stacked in the third direction D3, however, the inventive concepts are not limited thereto.

Referring to FIG. 44, a fifth insulation pattern 991 may extend through the fifth substrate 990, and a fifth through via 992 may extend through the fifth substrate 990. The fifth through via 992 may electrically connect the tenth wiring 720 of a lower semiconductor device to the first wiring 360 of an upper semiconductor device.

An upper wiring structure may be further disposed on the upper semiconductor device.

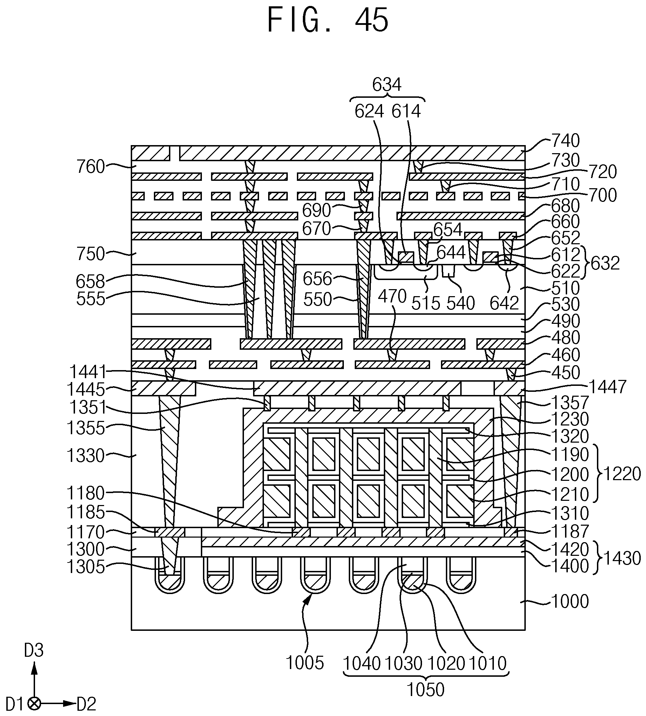

FIG. 45 is a cross-sectional view illustrating a semiconductor device in accordance with an example embodiment.

The semiconductor device may be a buried channel array transistor (BCAT) DRAM device including a BCAT. The semiconductor device may be substantially the same as or similar to that of FIG. 1 or 2, except that the semiconductor device includes a BCAT DRAM device memory cells instead of a VCT DRAM device memory cells, and that the second plate electrode of the memory cells is arranged to face upwardly. Thus, only the cell array region in which the memory cells are disposed is illustrated.

Referring to FIG. 45, a plurality of third gate structures 1050, each of which may extend in the first direction D1, may be spaced apart from each other in the second direction D2 on a sixth substrate 1000.

Each of the third gate structures 1050 may be disposed in a trench 1005 on the sixth substrate 1000, and may include a fifth gate insulation pattern 1010 on an inner wall of the trench 1005, and seventh and eighth conductive patterns 1020 and 1030 and a gate mask 1040, which may be sequentially stacked on the fifth gate insulation pattern 1010 in the third direction D3 and fill the trench 1005.

The fifth gate insulation pattern 1010 may include oxide (e.g., silicon oxide), the seventh conductive pattern 1020 may include metal (e.g., tungsten, molybdenum, etc.), or metal nitride (e.g., titanium nitride), the eighth conductive pattern 1030 may include, for example, doped polysilicon, and the gate mask 1040 may include insulating nitride (e.g., silicon nitride).

A plurality of second bit line structures 1430, each of which may extend in the second direction D2, may be spaced apart from each other in the first direction D1 on an upper surface of the sixth substrate 1000. Each of the second bit line structures 1430 may include ninth and tenth conductive patterns 1400 and 1420 sequentially stacked in the third direction D3. The ninth conductive pattern 1400 may include, for example, doped polysilicon, and the tenth conductive pattern 1420 may include metal (e.g., tungsten). In some example embodiments, an eleventh conductive pattern including metal silicon nitride (e.g., titanium silicon nitride) may be further disposed between the ninth and tenth conductive patterns 1400 and 1420.

A twelfth insulating interlayer 1300 may be disposed on the sixth substrate 1000, and may cover a sidewall of the second bit line structure 1430. A thirteenth insulating interlayer 1170 may be disposed on the twelfth insulating interlayer 1300 and the second bit line structure 1430.

Ninth to eleventh conductive pads 1180, 1185 and 1187 may be disposed in the thirteenth insulating interlayer 1170. Each of the ninth to eleventh conductive pads 1180, 1185 and 1187 may include twelfth and thirteenth conductive patterns sequentially stacked, the twelfth conductive pattern may include, for example, doped polysilicon, and the thirteenth conductive pattern may include, for example, metal, metal nitride, and metal silicide.

A twenty-fifth contact plug 1305 may extend through the twelfth insulating interlayer 1300, the gate mask 1040 and the eighth conductive pattern 1030 and contact an upper surface of the seventh conductive pattern 1020 under the tenth conductive pad 1185.

A second plate electrode 1230 may be disposed on the thirteenth insulating interlayer 1170, and may cover an upper surface and a sidewall of a second capacitor 1220. The second capacitor 1220 may include a third capacitor electrode 1190, a second dielectric layer 1200 and a fourth capacitor electrode 1210, and a third etch stop layer 1310 and a second support layer 1320 may be disposed on a sidewall of the third capacitor electrode 1190. The third capacitor electrode 1190 may contact an upper surface of the ninth conductive pad 1180.

A fourteenth insulating interlayer 1330 may disposed on the thirteenth insulating interlayer 1170, and may cover the second plate electrode 1230. Nineteenth to twenty-first wirings 1441, 1445 and 1447 may be disposed in the fourteenth insulating interlayer 1330. A twenty-sixth contact plug 1351 may be disposed between the nineteenth wiring 1441 and the second plate electrode 1230, a twenty-seventh contact plug 1355 may be formed between the twentieth wiring 1445 and the tenth conductive pad 1185, and a twenty-eighth contact plug 1357 may be disposed between the twenty-first wiring 1447 and the eleventh conductive pad 1187.

Thus, the nineteenth wiring 1441 may be electrically connected to the second plate electrode 1230, the twentieth wiring 1445 may be electrically connected to the third gate structure 1050, and the twenty-first wiring 1447 may be electrically connected to the second bit line structure 1430.

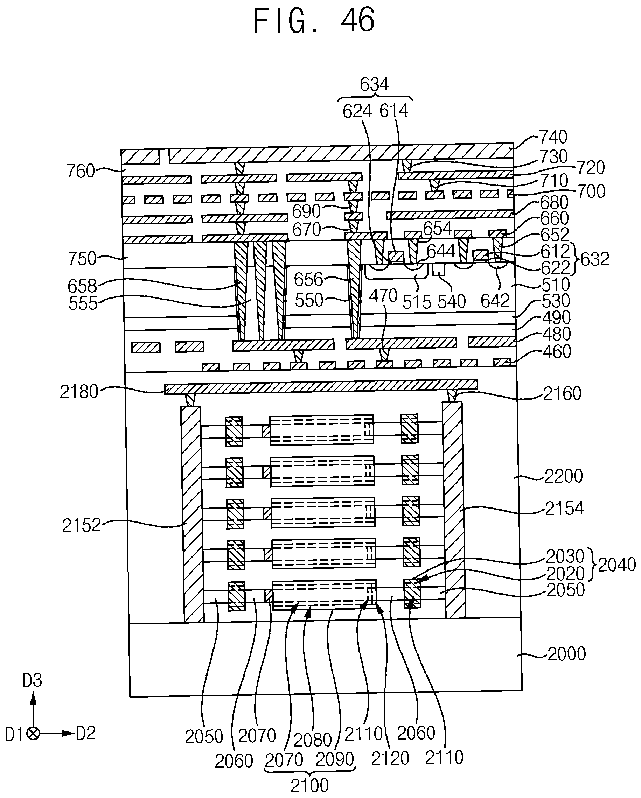

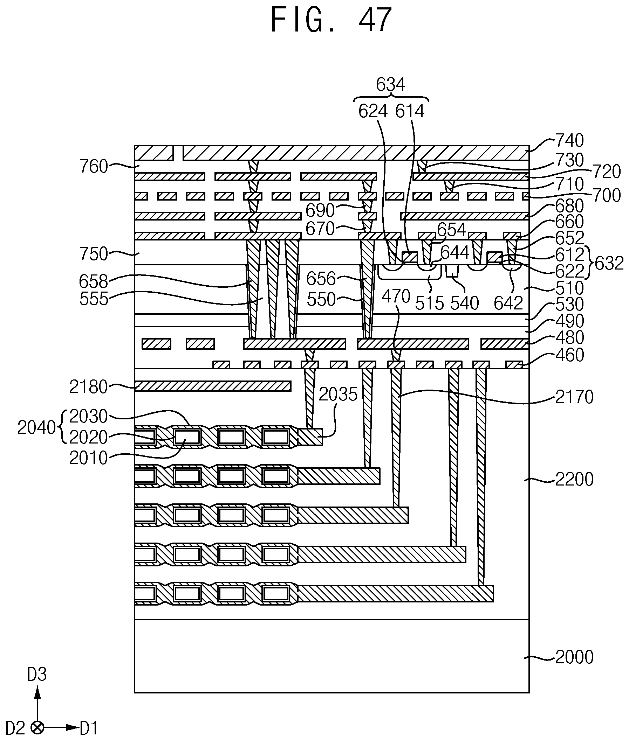

FIGS. 46 and 47 are cross-sectional views illustrating a semiconductor device in accordance with an example embodiment. FIG. 46 is a cross-sectional view in the second direction D2, and FIG. 47 is a cross-sectional view in the first direction D1.

The semiconductor device may be a vertically stacked DRAM (VS-DRAM) device. The semiconductor device may be substantially the same as or similar to that of FIG. 1 or 2, except that the semiconductor device includes memory cells of a VS-DRAM device instead of the memory cells of the VCT DRAM device, and that the second plate electrode of the memory cells is arranged to face upwardly. Thus, only the cell array region in which the memory cells are formed is illustrated.

Referring to FIGS. 46 and 47, the semiconductor device may include a second channel 2010, a fourth gate structure 2040, first and second source/drain patterns 2050 and 2060, a third capacitor 2100, a sixth insulation pattern 2110, a connection pattern 2120, third and fourth bit line structures 2152 and 2154, a twelfth conductive pad 2035, twenty-ninth and thirtieth contact plugs 2160 and 2170, and a twenty-second wiring 2180 on a seventh substrate 2000. A fifteenth insulating interlayer 2200 may be disposed between the seventh substrate 2000 and the fifth insulating interlayer 490, and may cover the second channel 2010, the fourth gate structure 2040, the first and second source/drain patterns 2050 and 2060, the third capacitor 2100, the sixth insulation pattern 2110, the connection pattern 2120, the third and fourth bit line structures 2152 and 2154, the twelfth conductive pad 2035, the twenty-ninth and thirtieth contact plugs 2160 and 2170, and the twenty-second wiring 2180.

Each of the third and fourth bit line structures 2152 and 2154 may extend in the third direction D3 on the seventh substrate 2000. A plurality of third bit line structures 2152 may be spaced apart from each other in the first direction D1, and a plurality of fourth bit line structures 2154 may be spaced apart from each other in the first direction D1. The third and fourth bit line structures 2152 and 2154 disposed in the second direction D2 may collectively form a bit line structure pair. In some example embodiments, a plurality of bit line structure pairs may be spaced apart from each other in the first direction D1.

A memory cell extending in the second direction D2 may be disposed between the third and fourth bit line structures 2152 and 2154. In some example embodiments, the memory cell may include the third capacitor 2100, a third transistor between the third capacitor 2100 and the third bit line structure 2152, and a fourth transistor between the third capacitor 2100 and the fourth bit line structure 2154. Each of the third and fourth transistors may include a second source/drain pattern 2060, a second channel 2010 and a first source/drain pattern 2050 sequentially stacked in the second direction D2 between the third capacitor 2100 and each of the third and fourth bit line structures 2152 and 2154, and a fourth gate structure 2040 surrounding the second channel 2010.

In some example embodiments, a plurality of memory cells may be spaced apart from each other in the third direction D3 between the third and fourth bit line structures 2152 and 2154 in each of the bit line structure pairs. A plurality of bit line structure pairs may be spaced apart from each other in the first direction D1, and thus a plurality of memory cells may be spaced apart from each other in the first direction D1, corresponding to the bit line structure pairs. FIGS. 46 and 47 show that the memory cells are disposed at five levels that are spaced apart from each other in the third direction D3 on the seventh substrate 2000, however, the inventive concepts are not limited thereto.

In some example embodiments, the third capacitor 2100 may include a fifth capacitor electrode 2070 having a shape of a pillar extending in the second direction D2, a third dielectric layer 2080 having a shape of a hollow cylinder that may cover a surface, that is, upper and lower surface and opposite sidewalls in the first direction D1 of the fifth capacitor electrode 2070, and a sixth capacitor electrode 2090 having a shape of a hollow cylinder that may cover a surface, that is, upper and lower surface and opposite outer sidewalls in the first direction D1 of the third dielectric layer 2080. However, the inventive concepts are not limited thereto, and for example, the fifth capacitor electrode 2070 may have a shape of a hollow cylinder instead of the pillar shape, and the sixth capacitor electrode 2090 may have a pillar shape instead of the hollow cylindrical shape.

In an example embodiment, the third dielectric layer 2080 may not cover a surface, that is, lower and upper surfaces and opposite sidewalls in the second direction D2 of a portion of the fifth capacitor electrode 2070 adjacent to the second source/drain pattern 2060 included in the third transistor.

In some example embodiments, a first sidewall in the second direction D2 of the fifth capacitor electrode 2070 may contact a sidewall in the second direction D2 of the second source/drain pattern 2060 included in the third transistor to be electrically connected thereto, while a second sidewall in the second direction D2 of the fifth capacitor electrode 2070 may not contact a sidewall in the second direction D2 of the second source/drain pattern 2060 included in the fourth transistor.

In some example embodiments, the sixth insulation pattern 2110 and the connection pattern 2120 may be sequentially arranged between the second sidewall of the fifth capacitor electrode 2070 and the sidewall in the second direction D2 of the second source/drain pattern 2060 included in the fourth transistor, and may contact the second sidewall of the fifth capacitor electrode 2070 and the sidewall in the second direction D2 of the second source/drain pattern 2060 included in the fourth transistor. Each of the sixth insulation pattern 2110 and the connection pattern 2120 may have the a shape of a pillar extending in the second direction D2, similar to the fifth capacitor electrode 2070.

In an example embodiment, a width in the first direction D1 and a thickness in the third direction D3 of the sixth insulation pattern 2110 may be substantially the same as a width in the first direction D1 and a thickness in the third direction D3, respectively, of the fifth capacitor electrode 2070, and a width in the first direction D1 and a thickness in the third direction D3 of the connection pattern 2120 may be substantially the same as a width in the first direction D1 and a thickness in the third direction D3, respectively, of a structure including the fifth capacitor electrode 2070 and the third dielectric layer 2080.

The sixth insulation pattern 2110 may include an insulating material. The connection pattern 2120 may include a semiconductor material doped with n-type impurities or p-type impurities (e.g., silicon doped with n-type impurities or p-type impurities, silicon-germanium doped with n-type impurities or p-type impurities, etc.).

The sixth insulation pattern 2110 may be arranged between the second sidewall in the second direction D2 of the fifth capacitor electrode 2070 and the sidewall in the second direction D2 of the second source/drain pattern 2060 included in the fourth transistor, so that the fifth capacitor electrode 2070 may not be electrically connected to the second source/drain pattern 2060 included in the fourth transistor.

The third dielectric layer 2080 may cover not only the upper and lower surfaces and the opposite sidewalls in the first direction D1 of the fifth capacitor electrode 2070, but also a surface, that is, upper and lower surfaces and opposite sidewalls in the first direction D1 of the sixth insulation pattern 2110.

The sixth capacitor electrode 2090 may cover not only the upper and lower surfaces and the opposite outer sidewalls in the first direction D1 of the third dielectric layer 2080, but also a surface, that is, upper and lower surfaces and opposite sidewalls in the first direction the first direction D1 of the connection pattern 2120. Thus, the sixth capacitor electrode 2090 may contact the connection pattern 2120, so as to be electrically connected to the second source/drain pattern 2060 included in the fourth transistor. The sixth capacitor electrode 2090 may be spaced apart from the second source/drain pattern 2060 included in the third transistor, and thus may not be electrically connected to the second source/drain pattern 2060 included in the third transistor.

Each of the first and second capacitor electrodes 2070 and 2090 may include a conductive material (e.g., metal, metal nitride, metal silicide, and doped silicon-germanium, etc.). The third dielectric layer 2080 may include metal oxide having a relatively high dielectric constant (e.g., hafnium oxide, zirconium oxide, etc.).

The second channel 2010 may include a semiconductor material (e.g., silicon, germanium, silicon-germanium, etc.). In some example embodiments, the second channel 2010 may include an oxide semiconductor material (e.g., indium gallium zinc oxide (IGZO)).

Each of the first and second source/drain patterns 2050 and 2060 may include a material substantially the same as the second channel 2010, however, n-type or p-type impurities may be doped into each of the first and second source/drain patterns 2050 and 2060. The first and second source/drain patterns 2050 and 2060 may include impurities having the same conductivity type.

In some example embodiments, the fourth gate structure 2040 may include a sixth gate insulation pattern 2020 covering a surface, that is, upper and lower surfaces and opposite sidewalls in the first direction D1 of the second channel 2010, and a fifth gate electrode 2030 covering a surface, that is, upper and lower surfaces and opposite outer sidewalls in the first direction D1 of the sixth gate insulation pattern 2020. Thus, the second channel 2010 may extend through the fourth gate structure 2040 in the second direction D2, and the fourth gate structure 2040 may have a gate all around (GAA) structure that may cover the second channel 2010.

In some example embodiments, the fourth gate structure 2040 may have a single gate structure or a double gate structure, instead of the GAA structure.

In some example embodiments, a length in the first direction D1 of the fourth gate structure 2040 may gradually increase form an uppermost level to a lowermost level, and thus the fourth gate structure 2040 may have a staircase shape. Each of opposite end portions in the first direction D1 of the fifth gate electrode 2030 included in each of the fourth gate structures 2040 may be referred to a twelfth conductive pad 2035.

The fifth gate electrode 2030 may include a conductive material (e.g., metal, metal nitride, metal silicide, etc.), and the sixth gate insulation pattern 2020 may include oxide (e.g., silicon oxide, metal oxide, etc.).

The twenty-ninth contact plug 2160 may contact upper surfaces of the third and fourth bit line structures 2152 and 2154 and a lower surface of the twenty-second wiring 2180, and the thirtieth contact plugs 2170 may contact upper surfaces of the twelfth conductive pads 2035, respectively. In an example embodiment, the twenty-second wiring 2180 may extend through in the second direction D2.

The semiconductor device in FIG. 45 and 46 may have a structure corresponding to the semiconductor device of FIGS. 1 and 2, or may have a structure corresponding to the semiconductor device of each of FIGS. 15, 18, 21, 24 to 26, 27, 29, 31, 33, 34, 41 to 43 and 44.

For example, each of the BCAT DRAM device and the VS-DRAM device may have the POC structure or the COP structure, the plate electrode in the cell array region may be arranged to face upwardly or downwardly, the transistors in the periphery circuit region may be disposed on a substrate to face upwardly or may be disposed under the substrate to face downwardly, and the cell array region or the periphery circuit region may be arranged at a single level or a plurality of levels in the vertical direction.

The foregoing is illustrative of some example embodiments and is not to be construed as limiting thereof. Although a few example embodiments have been described, those skilled in the art will readily appreciate that many modifications are possible in the example embodiments without materially departing from the novel teachings and advantages of the present inventive concepts. Accordingly, all such modifications are intended to be included within the scope of the present inventive concepts as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device comprising:
a transistor on a substrate;
a first wiring structure on the transistor, a portion of the first wiring structure being electrically connected to the transistor;
an insulation pattern extending through the substrate;
a second wiring structure under the substrate;
a plurality of through vias in the insulation pattern and spaced apart from each other in a horizontal direction parallel to an upper surface of the substrate, each of the plurality of through vias extending through the insulation pattern and contacting a portion of each of the first and second wiring structures;
a bit line structure under the second wiring structure, the bit line structure being electrically connected to a portion of the second wiring structure;
a gate electrode under the bit line structure, the gate electrode being electrically connected to a portion of the second wiring structure;
a channel adjacent to the gate electrode, the channel contacting the bit line structure; and
a capacitor under the channel, the capacitor being electrically connected to the channel.

2. The semiconductor device according to claim 1, further comprising:
a plate electrode covering a lower surface and a sidewall of the capacitor.

3. The semiconductor device according to claim 2, further comprising:
a first conductive pad between and in contact with the channel and the capacitor;
a second conductive pad at a same level as the first conductive pad, the second conductive pad being spaced apart from the first conductive pad in the horizontal direction;
a wiring under the plate electrode;
a first contact plug in contact with a lower surface of the plate electrode and an upper surface of the wiring; and
a second contact plug in contact with the upper surface of the wiring and a lower surface of the second conductive pad, a width of the second contact plug gradually decreasing from a bottom to a top thereof in a vertical direction perpendicular to the upper surface of the substrate.

4. The semiconductor device according to claim 3, further comprising:
a third contact plug in contact with an upper surface of the second conductive pad and a portion of the second wiring structure, a width of the third contact plug gradually increasing from a bottom to a top thereof in the vertical direction.

5. The semiconductor device according to claim 2, further comprising:
a first conductive pad between and in contact with the channel and the capacitor;
a wiring under the plate electrode;
a first contact plug in contact with a lower surface of the plate electrode and an upper surface of the wiring; and
a second contact plug in contact with the upper surface of the wiring and a portion of the second wiring structure, a width of the second contact plug gradually increasing from a bottom to a top thereof in a vertical direction perpendicular to the upper surface of the substrate.

6. The semiconductor device according to claim 2, wherein the plate electrode further includes:
a first conductive pattern including doped silicon-germanium; and
a second conductive pattern covering a lower surface and a sidewall of the first conductive pattern, the second conductive pattern including metal, and
wherein the semiconductor device further comprises a contact plug in contact with an upper surface of the first conductive pattern and a portion of the second wiring structure.

7. The semiconductor device according to claim 2, wherein the plate electrode further includes:
a first conductive pattern including doped silicon-germanium; and
a second conductive pattern covering a lower surface and a sidewall of the first conductive pattern, the second conductive pattern including metal, and
wherein the semiconductor device further comprises a contact plug in contact with an upper surface of the second conductive pattern and a portion of the second wiring structure.

8. The semiconductor device according to claim 2, further comprising:
a first conductive pad between and in contact with the channel and the capacitor;
a second conductive pad at a same level as the first conductive pad, the second conductive pad being spaced apart from the first conductive pad in the horizontal direction;
a wiring under the plate electrode;
a first contact plug in contact with a lower surface of the plate electrode and an upper surface of the wiring;
a dummy capacitor in contact with a lower surface of the second conductive pad, the dummy capacitor having a same structure as the capacitor; and
a second contact plug in contact with the upper surface of the wiring and a lower surface of the dummy capacitor.

9. The semiconductor device according to claim 1, wherein the plurality of through vias are disposed at each of opposite sides in a direction of the insulation pattern in a plan view.

10. The semiconductor device according to claim 1, wherein the plurality of through vias are disposed at a middle portion of the insulation pattern in a plan view.

11. The semiconductor device according to claim 1, wherein
the second wiring structure includes first and second wirings spaced apart from each other in a vertical direction perpendicular to the upper surface of the substrate,
the semiconductor device further comprises a bonding layer structure including a bonding pattern structure therein, the bonding pattern structure contacting the first and second wirings, and
the bonding pattern structure includes copper, and the bonding layer structure includes silicon carbonitride or silicon oxide.

12. The semiconductor device according to claim 1, wherein the first wiring structure includes a signal line and a power line, and the second wiring structure includes a signal line.

13. A semiconductor device comprising:
a transistor under a substrate;
a first wiring structure under the transistor, a portion of the first wiring structure being electrically connected to the transistor;
an insulation pattern extending through the substrate;
a second wiring structure on the substrate;
a plurality of through vias in the insulation pattern and spaced apart from each other in a horizontal direction parallel to an upper surface of the substrate, each of the plurality of through vias extending through the insulation pattern and contacting a portion of each of the first and second wiring structures;
a bit line structure on the second wiring structure, the bit line structure being electrically connected to a portion of the second wiring structure;
a gate electrode on the bit line structure, the gate electrode being electrically connected to a portion of the second wiring structure;
a channel adjacent to the gate electrode, the channel contacting the bit line structure; and
a capacitor on the channel, the capacitor being electrically connected to the channel.

14. The semiconductor device according to claim 13, further comprising:
a plate electrode covering an upper surface and a sidewall of the capacitor.

15. The semiconductor device according to claim 14, further comprising,
a first conductive pad between and in contact with the channel and the capacitor;
a wiring on the plate electrode;
a first contact plug in contact with an upper surface of the plate electrode and a lower surface of the wiring; and
a second contact plug in contact with the lower surface of the wiring and a portion of the second wiring structure, a width of the second contact plug gradually decreasing from a top to a bottom thereof in a vertical direction perpendicular to the upper surface of the substrate.
